# EUROPEAN PATENT APPLICATION

(11) **EP 2 826 800 A1**
(43) Date of publication of application: **21.01.2015**
(21) Application number: 13761906.0
(22) Date of filing: 12.03.2013
(51) Int. Cl.: C08G 59/40, B32B 15/08, C08J 5/24, C08K 3/20, C08K 5/54, C08L 63/00, H05K 1/03

(54) **RESIN COMPOSITION, PREPREG, AND METAL FOIL-CLAD LAMINATE**

(30) Priority: 13.03.2012 JP 2012055598; 11.06.2012 JP 2012131983
(71) Applicant: Mitsubishi Gas Chemical Company, Inc., Tokyo 100-8324 (JP)
(72) Inventor: TAKADA, Keisuke, Tokyo 125-8601 (JP); HIRANO, Syunsuke, Tokyo 125-8601 (JP); MORISHITA, Koji, Tokyo 125-8601 (JP); KAWAI, Hidetoshi, Tokyo 125-8601 (JP); KOGA, Yuichi, Tokyo 125-8601 (JP); KATO, Yoshihiro, Tokyo 125-8601 (JP)
(74) Representative: Hoffmann Eitle
(86) International application number: PCT/JP2013/056817
(87) International publication number: WO 2013/137257

(57) **Abstract**

Provided are a resin composition that can realize a prepreg, a metal foil-clad laminate and the like high in light reflectance in an ultraviolet region and in a visible light region, small in the reduction in light reflectance due to a heating treatment and a light irradiation treatment, good in peel strength of metal foil, also excellent in heat resistance after moisture absorption, also good in outer appearance, and also excellent in preservation stability, and a prepreg, a metal foil-clad laminate and the like using the same. The resin composition of the present invention contains at least an epoxy-modified silicone compound (A), a branched imide resin (B) having an isocyanurate group and a carboxyl group, a phosphorus curing accelerator (C), titanium dioxide (D) and a dispersant (E). The branched imide resin (B) is preferably at least one selected from the group consisting of an epoxy-modified branched imide resin, an alcohol-modified branched imide resin and an amine-modified branched imide resin.

## Description

### Technical Field

The present invention relates to a resin composition, and a prepreg, a metal foil-clad laminate and a printed-wiring board using the same, and particularly relates to a resin composition, a prepreg and a metal foil-clad laminate that can be suitably used in a printed-wiring board material, in particular, a light-emitting diode (LED)-mounting printed-wiring board or the like.

### Background Art

Conventionally, as an LED-mounting printed-wiring board, e.g. a laminate obtained by impregnating a glass woven fabric with an epoxy resin containing titanium dioxide and thereafter curing the resultant by heating has been known (see, for example, Patent Document 1.). This type of the laminate using an epoxy resin, however, is usually low in heat resistance, and thus the surface of a substrate can be discolored due to a heating treatment in a step of producing a printed-wiring board or in an LED-mounting step, or due to heating or light irradiation in use after LED-mounting, thereby causing the problem of a remarkable reduction in reflectance.

Since LEDs emitting short-wavelength light such as a blue color or a white color have become particularly popular in recent years, a laminate for use in an LED-mounting printed-wiring board has been demanded to be a laminate excellent in, particularly, heat resistance and light resistance. More specifically, a laminate is demanded which is excellent in heat resistance, and which not only has a high light reflectance in an ultraviolet region and in a visible light region but also less causes the reduction in light reflectance due to a heating treatment or a light irradiation treatment. As such a laminate in which the reduction in reflectance in short-wavelength light irradiation is suppressed, for example, a prepreg including a resin composition containing a bisphenol A novolac-based epoxy resin, an alicyclic epoxy resin and titanium dioxide, and a substrate has been proposed (see, for example, Patent Document 2.).

On the other hand, a silicone laminate obtained by impregnating a glass cloth with an addition curing type silicone resin composition containing an organopolysiloxane and an organohydrogenpolysiloxane each having a specific resin structure, a platinum group metal-based catalyst and a filler, and curing the resultant by heating is known to be excellent in mechanical characteristics, heat resistance and discoloration resistance, low in tack of the surface, and small in the reduction in light reflectance in heating and light irradiation (see, for example, Patent Document 3.).

### Citation List

### Patent Documents

Patent Document 1: Japanese Patent Application Laid-Open No. 10-202789
Patent Document 2: Japanese Patent Application Laid-Open No. 2008-001880
Patent Document 3: Japanese Patent Application Laid-Open No. 2010-089493

### Summary of Invention

### Technical Problem

LEDs, however, have progressed to have further higher luminance and higher output, and furthermore, the application field of LEDs has been extending from small display applications such as conventional mobile phones and car navigation to large display applications such as televisions and also residential illumination applications. Therefore, a laminate is demanded which has still more enhanced performances against discoloration and degradation due to heat or light than conventional one.

In particular, a laminate for printed-wiring boards is demanded to be high in adhesiveness (peel strength) with metal foil on which the laminate is layered when used as a metal foil-clad laminate, and furthermore is demanded to be high in heat resistance when reflow is performed by a lead-free solder. A resin composition that can realize a printed-wiring board excellent in all of these characteristics, however, has not been developed yet, causing the problems of mounting properties in a mounting step and of reliability in use after mounting.

The present invention has been made in view of the above problems, and an object thereof is to provide a resin composition that can realize a prepreg, a metal foil-clad laminate and the like having a high light reflectance in an ultraviolet region and in a visible light region, being small in the reduction in light reflectance due to a heating treatment and a light irradiation treatment, good in peel strength of metal foil, also excellent in heat resistance after moisture absorption, also good in outer appearance and also excellent in preservation stability, as well as a prepreg, a metal foil-clad laminate and a printed-wiring board using this.

### Solution to Problem

The present inventors have made intensive studies in order to solve the problems, and as a result, have found that a resin composition containing at least an epoxy-modified silicone compound, a branched imide resin having an isocyanurate group and a carboxyl group, a phosphorus curing accelerator, titanium dioxide and a dispersant can be used to provide a prepreg, a metal foil-clad laminate and the like high in light reflectance in an ultraviolet region and in a visible light region, small in the reduction in light reflectance due to a heating treatment and a light irradiation treatment, good in peel strength of metal foil, also excellent in heat resistance after moisture absorption, also good in outer appearance, and also excellent in preservation stability, leading to the present invention.

That is, the present invention provides the following <1> to <29>.
<1> A resin composition containing an epoxy-modified silicone compound (A), a branched imide resin (B) having an isocyanurate group and a carboxyl group, a phosphorus curing accelerator (C), titanium dioxide (D) and a dispersant (E).
<2> The resin composition according to <1>, wherein the branched imide resin (B) is at least one selected from the group consisting of an epoxy-modified branched imide resin, an alcohol-modified branched imide resin and an amine-modified branched imide resin.
<3> The resin composition according to <1> or <2>, wherein the branched imide resin (B) has an acid value of 10 to 200 mgKOH/g.
<4> The resin composition according to any one of <1> to <3>, wherein the branched imide resin (B) has an acid value of 10 to 100 mgKOH/g.
<5> The resin composition according to any one of <1> to <4>, further containing a monomeric epoxy compound (F) having one or more epoxy rings, other than the compound (A).
<6> The resin composition according to <5>, wherein an epoxy equivalent of the monomeric epoxy compound (F) is 0.1 to 0.8 equivalents relative to a carboxyl residue of the branched imide resin (B).
<7> The resin composition according to <5> or <6>, wherein the monomeric epoxy compound (F) is at least one selected from the group consisting of compounds represented by the following formulae (8) to (10). 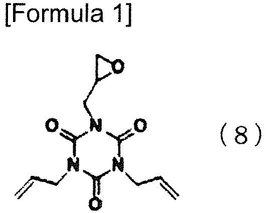 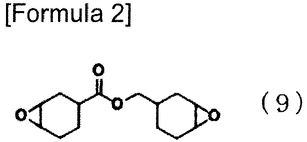 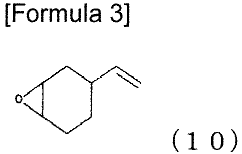
<8> The resin composition according to any one of <1> to <7>, wherein the epoxy-modified silicone compound (A) is an aliphatic epoxy-modified silicone compound.
<9> The resin composition according to any one of <1> to <8>, wherein the epoxy-modified silicone compound (A) is a silicone compound having a repeating unit represented by the following formula (1), having at least three R'(s) in one molecule, and not having any alkoxy groups: 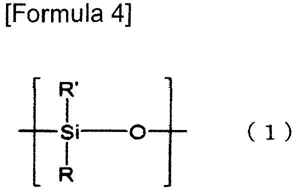 wherein R represents a hydrogen atom, or a substituted or non-substituted monovalent hydrocarbon group, and R' represents an organic group having an epoxy group.
<10> The resin composition according to any one of <1> to <9>, containing the epoxy-modified silicone compound (A) in an amount of 20 to 80 parts by mass based on 100 parts by mass of the total of the components (A) and (B).
<11> The resin composition according to any one of <1> to <10>, wherein the branched imide resin (B) is represented by the following formula (6): 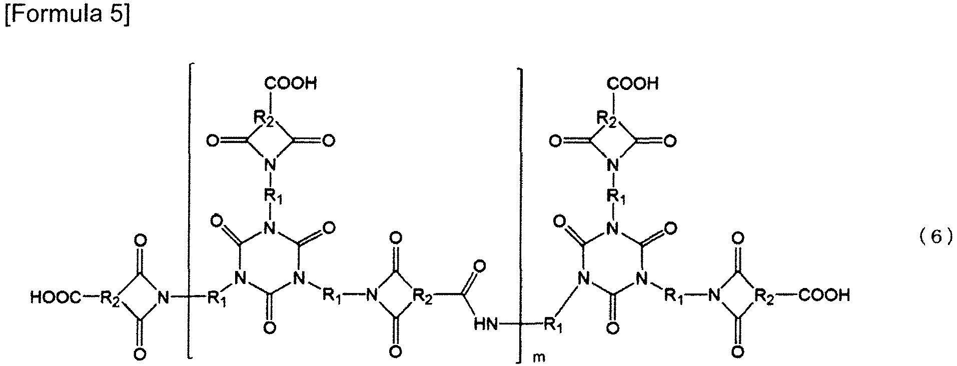 wherein each R₁ independently represents a divalent alicyclic group, each R₂ independently represents a trivalent alicyclic group, and m represents an integer of 1 to 10.
<12> The resin composition according to any one of <1> to <11>, further containing a silane coupling agent (H).
<13> The resin composition according to any one of <1> to <12>, containing the phosphorus curing accelerator (C) in an amount of 0.1 to 10 parts by mass based on 100 parts by mass of the total of the components (A) and (B).
<14> The resin composition according to any one of <1> to <13>, containing the titanium dioxide (D) in an amount of 10 to 300 parts by mass based on 100 parts by mass of the total of the components (A) and (B).
<15> The resin composition according to any one of <1> to <14>, wherein the titanium dioxide (D) has an average particle size of 5 µm or less.
<16> The resin composition according to any one of <1> to <15>, wherein the titanium dioxide (D) has a surface treated with SiO₂, Al₂O₃, ZrO₂ and/or ZnO; and SiO₂ is contained in an amount of 0.5 to 15 parts by mass, Al₂O₃ is contained in an amount of 0.5 to 15 parts by mass, ZrO₂ is contained in an amount of 0.5 to 15 parts by mass and/or ZnO is contained in an amount of 0.5 to 15 parts by mass, based on 100 parts by mass of the total amount of the titanium dioxide (D).
<17> The resin composition according to any one of <1> to <16>, containing the dispersant (E) in an amount of 0.05 to 10 parts by mass based on 100 parts by mass of the total of the components (A) and (B).
<18> The resin composition according to any one of <1> to <17>, wherein the dispersant (E) is a polymer-based wetting dispersant having an acid value of 20 to 200 mgKOH/g.
<19> The resin composition according to any one of <1> to <18>, further containing an alicyclic epoxy resin (G).
<20> The resin composition according to <19>, wherein the alicyclic epoxy resin (G) is at least one selected from the group consisting of an alcohol adduct of vinylcyclohexene diepoxide, an alcohol adduct of 3,4-epoxycyclohexanecarboxylic acid-3',4'-epoxycyclohexylmethyl, an alcohol adduct of bis(3,4-epoxycyclohexylmethyl) adipate, an alcohol adduct of dicyclopentadiene diepoxide, an alcohol adduct of ε-caprolactone-modified bis(3,4-epoxycyclohexylmethyl)-4,5-epoxycyclohexane-1,2-dicarboxylic acid, an alcohol adduct of ε-caprolactone-modified tetra(3,4-epoxycyclohexylmethyl)butane-tetracarboxylic acid, an alcohol adduct of dipentene dioxide, an alcohol adduct of 1,4-cyclooctadiene diepoxide and an alcohol adduct of bis(2,3-epoxycyclopentyl)ether.
<21> The resin composition according to <5>, prepared by subjecting the branched imide resin (B), the phosphorus curing accelerator (C) and the monomeric epoxy compound (F) to a pretreatment with reflux in the presence of a solvent, and then blending the epoxy-modified silicone compound (A), the titanium dioxide (D) and the dispersant (E) therewith.
<22> A resin composition containing an epoxy-modified silicone compound (A), a branched imide resin (B) having an isocyanurate group and a carboxyl group, a phosphorus curing accelerator (C), titanium dioxide (D), a dispersant (E), a monomeric epoxy compound (F) having one or more epoxy rings, other than the (A), and an alicyclic epoxy resin (G), wherein the resin composition contains the branched imide resin (B) in an amount of 10 to 80 parts by mass based on 100 parts by mass of the total of the epoxy-modified silicone compound (A), the branched imide resin (B), the monomeric epoxy compound (C) and the alicyclic epoxy resin (G).
<23> The resin composition according to <22>, containing the titanium dioxide (D) in an amount of 10 to 400 parts by mass based on 100 parts by mass of the total of the epoxy-modified silicone compound (A), the branched imide resin (B), the monomeric epoxy compound (F) and the alicyclic epoxy resin (G).
<24> The resin composition according to <22> or <23>, containing the dispersant (E) in an amount of 0.05 to 5 parts by mass based on 100 parts by mass of the total of the epoxy-modified silicone compound (A), the branched imide resin (B), the monomeric epoxy compound (F) and the alicyclic epoxy resin (G).
<25> A resin composition containing an epoxy-modified silicone compound (A), a branched imide resin (B) having an isocyanurate group and a carboxyl group, titanium dioxide (D), a dispersant (E), and a monomeric epoxy compound (F) having one or more epoxy rings, other than the (A). Preferably, this resin composition is also according to specific aspects described in <2> to <20>.
<26> The resin composition according to any one of <1> to <25> used for an LED-mounting printed-wiring board.
<27> A prepreg obtained by impregnating or coating a substrate with the resin composition according to any one of <1> to <25>.
<28> A metal foil-clad laminate obtained by stacking at least one or more sheets of the prepreg according to <27>, disposing metal foil on one or both surfaces of the resultant, and lamination-forming.
<29> A printed-wiring board comprising an insulation layer, and a conductor layer formed on a surface of the insulation layer, wherein the insulation layer includes the resin composition according to any one of <1> to <25>.

### Advantageous Effects of Invention

According to the present invention, the branched imide resin (B) having an isocyanurate group and a carboxyl group, and the phosphorus curing accelerator (C) are used in combination to thereby adjust the reaction speed in prepreg preparation, and therefore a resin composition and a prepreg can be realized which can simply, reproducibly and certainly realize a metal foil-clad laminate, a printed-wiring board and the like high in light reflectance in an ultraviolet region and in a visible light region, small in the reduction in light reflectance due to a heating treatment and a light irradiation treatment, good in peel strength of metal foil, also excellent in heat resistance after moisture absorption, also good in outer appearance, and excellent in preservation stability. In addition, use of the phosphorus curing accelerator (C) can suppress the activity of the branched imide resin (B) to prevent the increase in gelation time of a varnish and the increase in viscosity of a prepreg, and also to achieve the enhancement in preservation stability of a varnish and the enhancement in processability in prepreg preparation. Furthermore, according to a suitable aspect of the present invention, the monomeric epoxy compound is contained to result in the improvements in heat resistance and handleability, and also the improvement in prepreg-melting characteristics in heating, thereby resulting in a still further enhancement in formability of a metal foil-clad laminate. Therefore, the resin composition, the prepreg, the metal foil-clad laminate, and the like of the present invention can be suitably used for an LED-mounting printed-wiring board and the like, and industrial utilities thereof are extremely high.

### Description of Embodiment

Hereinafter, an embodiment of the present invention will be described. It is to be noted that the following embodiment is illustrative for describing the present invention and the present invention is not limited only to the embodiment.

A resin composition of the present embodiment is a so-called thermosetting resin composition to be cured by heat, and contains at least an epoxy-modified silicone compound (A), a branched imide resin (B) having an isocyanurate group and a carboxyl group, a phosphorus curing accelerator (C), titanium dioxide (D) and a dispersant (E).

The epoxy-modified silicone compound (A) for use in the resin composition of the present embodiment is not particularly limited as long as it is an organosilicon compound having an epoxy group, but is preferably an aliphatic epoxy-modified silicone compound prepared by introducing a substituted or non-substituted aliphatic hydrocarbon group having an epoxy group to a silicone compound having a siloxane bond (Si-O-Si bond) in a main backbone. When this epoxy-modified silicone compound (A) is used together with the branched imide resin (B) having an isocyanurate group and a carboxyl group, the phosphorus curing accelerator (C), the titanium dioxide (D) and the dispersant (E), not only the light reflectance in an ultraviolet region and in a visible light region of the resulting metal foil-clad laminate tends to be increased to suppress discoloration due to a heating treatment and a light irradiation treatment, suppressing the reduction in light reflectance, but also the peel strength of metal foil and the heat resistance tend to be significantly increased.

The epoxy-modified silicone compound is preferably a silicone compound having a repeating unit represented by the following formula (1), having at least three R' in one molecule and not having any alkoxy groups, and one in liquid state is more preferable because of being excellent in processability. The phrase "having a repeating unit represented by the following formula (1)" here encompasses both cases: a case of having a plurality (preferably 3 or more) of only one kind of units where R and/or R' are the same in all units, and a case of having a plurality (preferably 3 or more) of units where R and/or R' are different between units. 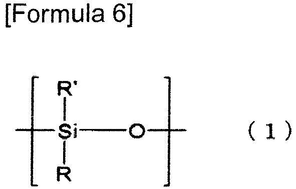 wherein R represents a hydrogen atom, or a substituted or non-substituted monovalent hydrocarbon group, and R' represents an organic group having an epoxy group.

In the formula (1), specific examples of the monovalent hydrocarbon group represented by R include a substituted or non-substituted aliphatic hydrocarbon group, and the number of carbon atoms thereof is preferably 1 to 20 and more preferably 1 to 8. More specifically, examples include alkyl groups such as a methyl group, an ethyl group, a propyl group, a butyl group, a hexyl group and an octyl group, and a group in which hydrogen atoms in such a monovalent hydrocarbon group are partially or entirely substituted with an epoxy group (however, excluding an epoxycyclohexyl group), a methacryl group, an acryl group, a mercapto group, an amino group or the like, but not particularly limited thereto. Among them, R is preferably a methyl group, an ethyl group or a hydrogen atom, and more preferably a methyl group.

In the formula (1), specific examples of the organic group represented by R' and having an epoxy group include a substituted or non-substituted aliphatic hydrocarbon group having an epoxy group, and the number of carbon atoms thereof is preferably 2 to 20 and more preferably 2 to 12. More specifically, examples include a glycidoxypropyl group and a 3,4-epoxycyclohexylethyl group, but not particularly limited thereto. In particular, R' is preferably an organic group having a 3,4-epoxycyclohexyl group from the viewpoint that cure shrinkage is small.

Herein, the silicone compound having the repeating unit represented by the formula (1) preferably has 3 to 8 of R' in one molecule. When the silicone compound having the unit represented by the formula (1) has R' in this range, a cured product high in hardness and also excellent in toughness tends to be easily obtained.

The silicone compound having the repeating unit represented by the formula (1) preferably has a degree of polymerization of 3 to 100. One having the degree of polymerization in this range is easily synthesized industrially, and thus is easily available. From the viewpoint of making it possible to not only achieve such characteristics but also further suppress cure shrinkage, the degree of polymerization is more preferably 3 to 50 and further preferably 3 to 10.

The silicone compound having the repeating unit represented by the formula (1) does not contain any alkoxy groups. Therefore, no cure shrinkage due to dealcoholization reaction is caused, and when the silicone compound is used in combination with the branched imide resin (B), excellent dielectric breakdown characteristics can be achieved.

Specific examples of the silicone compound having the repeating unit represented by the formula (1) include a compound having a linear structure or a ring structure.

Examples of the compound having a ring structure include a cyclic silicone compound represented by the following formula (2). The cyclic silicone compound represented by the following formula (2) is suitable because of being small in cure shrinkage. 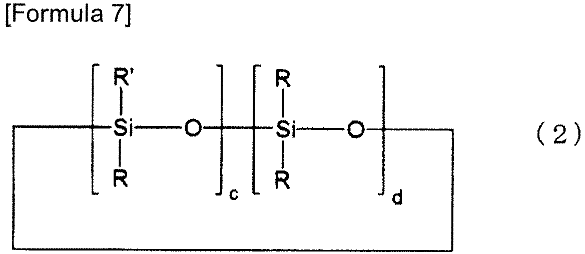 wherein R and R' are as defined in the formula (1); c represents an integer of 3 to 5, d represents an integer of 0 to 2, and the sum of c and d is equal to an integer of 3 to 5; and the repeating units can be randomly bonded.

In the formula (2), preferably, c represents an integer of 3 to 4, d represents an integer of 0 to 1, and the sum of c and d is equal to 4.

Among the cyclic silicone compound represented by the formula (2), a cyclic silicone compound represented by the following formula (2') is more preferable. 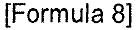 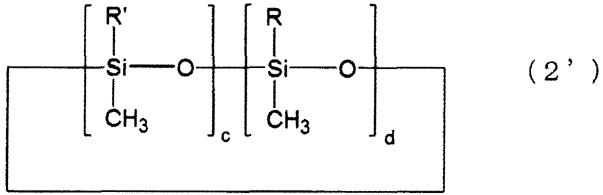 wherein R, R', c and d are as defined in the formulae (1) and (2).

Examples of the compound having a linear structure include a linear silicone compound represented by the following formula (3). 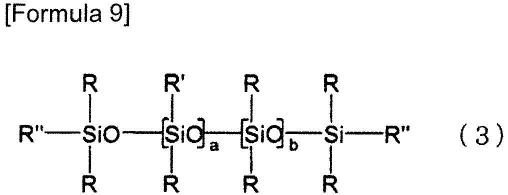 wherein R and R' are as defined in the formula (1), R" represents R or R', and R, R' and R" may be the same or different from one another; a represents an integer of 1 to 10, b represents an integer of 0 to 8, and the sum of a and b is equal to an integer of 2 to 10, provided that when a is 1, R" at both ends represent R', and that when a is 2, at least one R" represents R'; and the polymerization units can be randomly bonded.

In the formula (3), preferably, a represents an integer of 4 to 8, b represents an integer of 0 to 4, and the sum of a and b is equal to 4 to 8.

Among the linear silicone compound represented by the formula (3), a linear silicone compound represented by the following formula (3') is more preferable. 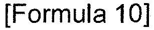 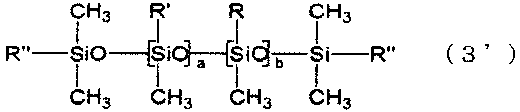 wherein R, R', R", a and b are as defined in the formulae (1) to (3).

Among the linear silicone compound represented by the formula (3), a linear silicone compound represented by the following formula (4) is further preferable. 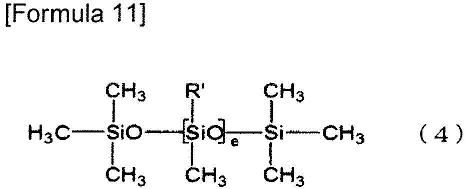 wherein R' is as defined in the formula (1), and e represents an integer of 3 to 10.

In the formula (4), e preferably represents an integer of 3 to 8.

The silicone compound having the repeating unit represented by the formula (1) is still further preferably a cyclic silicone compound represented by the following formula (5). 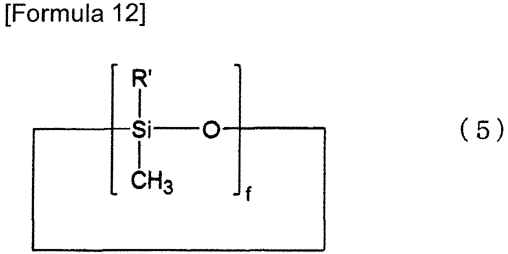 wherein R' is as defined in the formula (1), and f represents an integer of 3 to 5.

In the formula (5), f preferably represents 4.

One containing 50% by mass or more of the compound represented by the formula (5) in which f is 4 is particularly preferable.

Specific examples of the aliphatic epoxy-modified silicone compound include (CH₃)₃SiO(R'CH₃SiO)₅Si(CH₃)₃, (CH₃)₃SiO(R'CH₃SiO)₆Si(CH₃)₃, (CH₃)₃SiO(R'CH₃SiO)₇Si(CH₃)₃, (CH₃)₃SiO(R'CH₃SiO)₈Si(CH₃)₃, (CH₃)₃SiO(R'CH₃SiO)₉Si(CH₃)₃, (CH₃)₃SiO(R'CH₃SiO)₁₀Si(CH₃)₃, R'(CH₃)₂SiO(R-CH₃SiO)Si(CH₃)₂R', R'(CH₃)₂SiO(R'CH₃SiO)₂Si(CH₃)₂R'-R'(CH₃)₂SiO(R'CH₃SiO)₃Si(CH₃)₂R', R'(CH₃)₂SiO(R'CH₃SiO)₄Si(CH₃)₂R', R'(CH₃)₂SiO(R'CH₃SiO)₅Si(CH₃)₂R', R'(CH₃)₂SiO(R'CH₃SiO)₆Si(CH₃)₂R', R'(CH₃)₂SiO(R'CH₃SiO)₇Si(CH₃)₂R', R'(CH₃)₂SiO(R'CH₃SiO)₈Si(CH₃)₂R', R'(CH₃)₂SiO(R'CH₃SiO)₉Si(CH₃)₂R', R'(CH₃)₂SiO(R'CH₃SiO)₂((CH₃)₂SiO)₂Si(CH₃)₂R',

R'(CH₃)₂SiO(R'CH₃SiO)₃((CH₃)₂SiO)Si(CH₃)₂R', R'(CH₃)₂SiO(R'CH₃SiO)₃((CH₃)₂SiO)₂Si(CH₃)₂R', R'(CH₃)₂SiO(R'CH₃SiO)₄((CH₃)₂SiO)Si(CH₃)₂R', R'(CH₃)₂SiO(R'CH₃SiO)₄((CH₃)₂SiO)₂Si(CH₃)₂R', R'(CH₃)₂SiO(R'CH₃SiO)₅((CH₃)₂SiO)Si(CH₃)₂R', R'(CH₃)₂SiO(R'CH₃SiO)₅((CH₃)₂SiO)₂Si(CH₃)₂R', R'(CH₃)₂SiO(R'CH₃SiO)₅((CH₃)₂SiO)₃Si(CH₃)₂R', R'(CH₃)₂SiO(R'CH₃SiO)₆((CH₃)₂SiO)Si(CH₃)₂R',

R'(CH₃)₂SiO(R'CH₃SiO)₆((CH₃)₂SiO)₂Si(CH₃)₂R', R'(CH₃)₂SiO(R'CH₃SiO)₆((CH₃)₂SiO)₃Si(CH₃)₂R', R'(CH₃)₂SiO(R'CH₃SiO)₇((CH₃)₂SiO)Si(CH₃)₂R', R'(CH₃)₂SiO(R'CH₃SiO)₇((CH₃)₂SiO)₂Si(CH₃)₂R', R'(CH₃)₂SiO(R'CH₃SiO)₇((CH₃)₂SiO)₃Si(CH₃)₂R', R'(CH₃)₂SiO(R'CH₃SiO)₇((CH3)₂SiO)₄Si(CH₃)₂R', R'(CH₃)₂SiO(R'CH₃SiO)₈((CH₃)₂SiO)Si(CH₃)₂R', R'(CH₃)₂SiO(R'CH₃SiO)₈((CH₃)₂SiO)₂Si(CH₃)₂R', R'(CH₃)₂SiO(R'CH₃SiO)₈((CH₃)₂SiO)₃Si(CH₃)₂R',

R'(CH₃)₂SiO(R'CH₃SiO)₄(R⁰CH₃SiO)Si(CH₃)₂R', R'(CH₃)₂SiO(R'CH₃SiO)₅(R°CH₃SiO)Si(CH₃)₂R', R'(CH₃)₂SiO(R'CH₃SiO)₆(R⁰CH₃SiO)Si(CH₃)₂R', R'(CH₃)₂SiO(R'CH₃SiO)₇(R⁰CH₃SiO)Si(CH₃)₂R', R'(CH₃)₂SiO(R'CH₃SiO)₈(R⁰CH₃SiO)Si(CH₃)₂R', R'(CH₃)₂SiO(R'CH₃SiO)₉(R⁰CH₃SiO)Si(CH₃)₂R', (R'CH₃SiO)₃, (R'CH₃SiO)₄, (R'CH₃SiO)₅, (R'CH₃SiO)₃((CH₃)₂SiO), and (R'CH₃SiO)₃(C₃H₇(CH₃)SiO) but not particularly limited thereto. Herein, R' is as defined in the formula (1), and R⁰ represents a methacryloxypropyl group.

The above epoxy-modified silicone compound (A) can be produced by a known method, and a commercial product thereof is easily available. For example, the epoxy-modified silicone compound (A) can be obtained by addition-reacting (hydrosilylating) an allyl epoxy compound (for example, 4-vinylcyclohexene oxide) with an organohydrogenpolysiloxane using a catalyst such as a platinum compound. For example, X-40-2670, X-22-163A, X-22-163B, X-22-169AS, X-22-169B, X-41-1053, KF-105 and PRX413 (produced by Shin-Etsu Chemical Co., Ltd.), BY16-752A, BY16-799 and BY16-873 (produced by Dow Corning Toray Co., Ltd.), and SE-02CM (produced by Nagase Chemtex Corporation) are also commercially available. Herein, the epoxy-modified silicone compound can be used singly or in appropriate combination of two or more.

The content of the epoxy-modified silicone compound (A) in the resin composition of the present embodiment is not particularly limited, but is preferably 20 to 80 parts by mass and more preferably 25 to 75 parts by mass based on 100 parts by mass of the total of the epoxy-modified silicone compound (A) and the branched imide resin (B) from the viewpoint of suppressing the discoloration due to a heating treatment and a light irradiation treatment of a metal foil-clad laminate to be obtained.

The branched imide resin (B) for use in the resin composition of the present embodiment is not particularly limited as long as it has an isocyanurate ring, a carboxyl group and an imide group. Preferable is a branched imide resin having an isocyanurate ring and a plurality of cyclic imides having a carboxyl group, wherein a large number of the cyclic imides are bonded to the isocyanurate ring (hereinafter, also referred to as "multi-branched imide resin"). In addition, the branched imide resin (B) is more preferably an imide resin having an alicyclic structure, namely, an alicyclic imide resin (not having any aromatic rings). Examples of such an alicyclic imide resin include a branched alicyclic imide resin that has an isocyanurate ring and a plurality of aliphatic cyclic imides having a carboxylic group and bonded to each nitrogen atom on the isocyanurate ring via an aliphatic ring. When such a branched imide resin (B) having an isocyanurate ring and a carboxyl group is used together with the epoxy-modified silicone compound (A), the phosphorus curing accelerator (C), the titanium dioxide (D) and the dispersant (E), not only the peel strength of metal foil and the heat resistance tend to be significantly increased, but also the light reflectance in an ultraviolet region and in a visible light region tends to be significantly increased to remarkably suppress the reduction in light reflectance due to a heating treatment and a light irradiation treatment.

As the branched imide resin (B), for example, one represented by the following formula (6) is preferable. 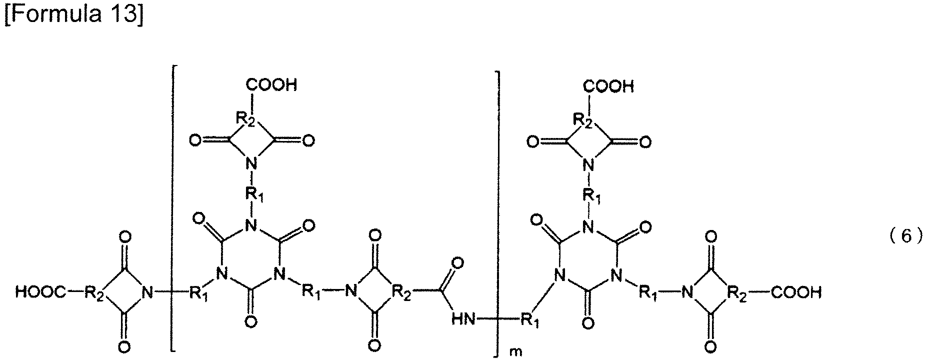 wherein each R₁ independently represents a divalent alicyclic group, each R₂ independently represents a trivalent alicyclic group, and m represents an integer of 1 to 10.

In the formula (6), the alicyclic group represented by R₁ is a divalent group containing an aliphatic ring and preferably having 6 to 20 carbon atoms, which is a residue of an alicyclic diamine or an alicyclic diisocyanate as a raw material. Examples of the alicyclic diamine include 4,4'-diamino-dicyclohexylmethane, 3,3'-dimethyl-4,4'-diamino-dicyclohexylmethane, 3,3'-diethyl-4,4'-diamino-dicyclohexylmethane, 3,3',5,5'-tetramethyl-4,4'-diamino-dicyclohexylmethane, 3,3',5,5'-tetraethyl-4,4'-diamino-dicyclohexylmethane, 3,5-diethyl-3',5'-dimethyl-4,4'-diaminodicyclohexylmethane, 1,4-cyclohexanediamine, 1,3-cyclohexanediamine, isophoronediamine, 2,2-bis[4-(4-aminocyclohexyloxy)cyclohexyl]propane, bis[4-(3-aminocyclohexyloxy)cyclohexyl]sulfone, bis[4-(4-aminocyclohexyloxy)cyclohexyl]sulfone, 2,2-bis[4-(4-aminocyclohexyloxy)cyclohexyl]hexafluoropropane, bis[4-(4-aminocyclohexyloxy)cyclohexyl]methane, 4,4'-bis(4-aminocyclohexyloxy)dicyclohexyl, bis[4-(4-aminocyclohexyloxy)cyclohexyl]ether, bis[4-(4-aminocyclohexyloxy)cyclohexyl]ketone, 1,3-bis(4-aminocyclohexyloxy)benzene, 1,4-bis(4-aminocyclohexyloxy)benzene, (4,4'-diamino)dicyclohexylether, (4,4'-diamino)dicyclohexylsulfone, (4,4'-diaminocyclohexyl)ketone, (3,3'-diamino)benzophenone, 2,2'-dimethylbicyclohexyl-4,4'-diamine, 2,2'-bis(trifluoromethyl)dicyclohexyl-4,4'-diamine, 5,5'-dimethyl-2,2'-sulfonyldicyclohexyl-4,4'-diamine, 3,3'-dihydroxydicyclohexyl-4,4'-diamine, (4,4'-diamino)dicyclohexylmethane, (4,4'-diamino)dicyclohexylether, (3,3'-diamino)dicyclohexylether and 2,2-bis(4-aminocyclohexyl)propane, but not particularly limited thereto. Examples of the alicyclic diisocyanate include one obtained by replacing an amino group of the above alicyclic diamine with an isocyanate group.

In the formula (6), the alicyclic group represented by R₂ is a trivalent aliphatic group containing an aliphatic ring and preferably having 6 to 20 carbon atoms, which is a residue of an alicyclic tricarboxylic acid or its anhydride as a raw material. Examples of the alicyclic tricarboxylic acid include cyclohexane-1,2,3-tricarboxylic acid, cyclohexane-1,2,4-tricarboxylic acid, cyclohexane-1,3,5-tricarboxylic acid, 5-methylcyclohexane-1,2,4-tricarboxylic acid, 6-methylcyclohexane-1,2,4-tricarboxylic acid and 3-methylcyclohexane-1,2,4-tricarboxylic acid, but not particularly limited thereto.

When the branched imide resin (B) is one represented by the formula (6), the mass average molecular weight (Mw) thereof is preferably 2,000 to 35,000 and more preferably 2,000 to 10,000.

In the branched imide resin (B), carboxyl groups in the molecular structure have curing acceleration ability in a curing reaction. Since the phosphorus curing accelerator (C) having curing acceleration ability is used in combination in the resin composition of the present embodiment, the branched imide resin (B) in which at least a part of carboxyl groups in the molecular structure are modified is preferable from the viewpoint of controlling the curing acceleration ability of the composition as a whole in a proper range. More specifically, preferable is a modified branched imide resin obtained by reacting at least a part of carboxyl groups in the molecular structure with at least one selected from the group consisting of an epoxy compound, an alcohol compound and an amine compound (epoxy-modified branched imide resin, alcohol-modified branched imide resin, or amine-modified branched imide resin). In particular, an epoxy-modified branched imide resin and an alcohol-modified branched imide resin are preferable, and an epoxy-modified branched imide resin is more preferable. Herein, the branched imide resin can be used singly or in combination of two or more.

The degree of modification of carboxyl groups in the molecular structure of the branched imide resin (B) can be determined in terms of the acid value. Herein, the acid value of the branched imide resin (B) is not particularly limited, but is preferably 10 to 200 mgKOH/g, more preferably 10 to 100 mgKOH/g, and further preferably 20 to 80 mgKOH/g on the solid content basis from the viewpoints of the solubility in an organic solvent, curing characteristics of the resulting resin composition, and the like.

The branched imide resin (B) can be produced by a known method, and a commercial product thereof is easily available. Commercially products of the branched imide resin (B) include a branched imide compound having a structure represented by the following formula (7) (trade name: V-8002 (produced by Dic Corporation)), one obtained by epoxy-modifying this branched imide compound (trade name: ELG-941 (produced by Dic Corporation)), one obtained by amine-modifying this branched imide compound (trade name: ELG-1301 (produced by Dic Corporation)), and one obtained by alcohol-modifying this branched imide compound (trade name: ELG-1302 (produced by Dic Corporation)). 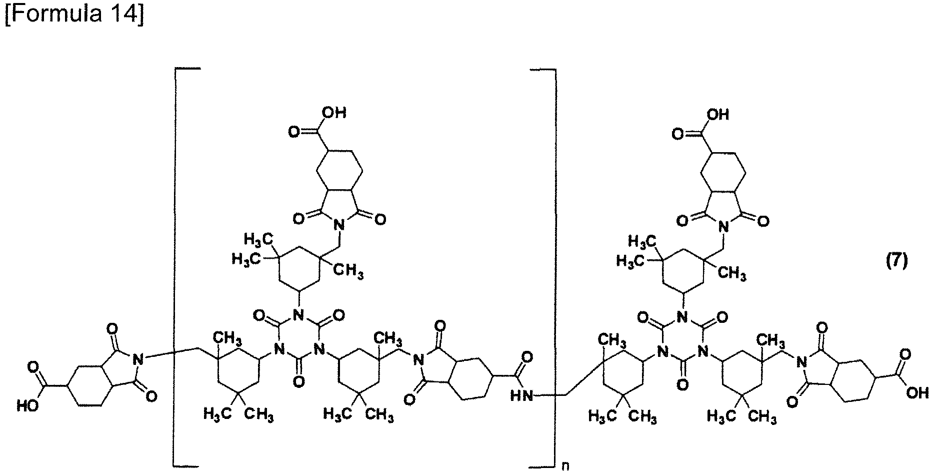 wherein n represents an integer of 1 to 10.

The content of the branched imide resin (B) in the resin composition of the present embodiment is not particularly limited, but is preferably 20 to 80 parts by mass and more preferably 25 to 75 parts by mass based on 100 parts by mass of the total of the epoxy-modified silicone compound (A) and the branched imide resin (B) from the viewpoints of increasing the peel strength of the resulting metal foil-clad laminate and suppressing discoloration due to a heating treatment and a light irradiation treatment.

The phosphorus curing accelerator (C) for use in the resin composition of the present embodiment is not particularly limited in terms of the type thereof as long as it is a compound containing phosphorus in its molecule and having curing acceleration ability. Specific examples thereof include methyltributylphosphonium dimethyl phosphate (trade name: PX-4MP (produced by Nippon Chemical Industrial Co., Ltd.)), butylphosphonium diethyl phosphodithioate (trade name: PX-4ET (produced by Nippon Chemical Industrial Co., Ltd.)), tetrabutylphosphonium tetrafluoroborate (trade name: PX-4FB (produced by Nippon Chemical Industrial Co., Ltd.)), triphenylphosphine (produced by Tokyo Chemical Industry Co., Ltd.) and phosphorus-containing cyanic acid ester (trade name: FR-300 (produced by Lonza Japan)). The phosphorus curing accelerator can be used singly or in appropriate combination of two or more. Among them, methyltributylphosphonium dimethyl phosphate is preferable from the viewpoints of the light reflectance due to a heating treatment and a light irradiation treatment as well as the glass transition temperature. Herein, use of this phosphorus curing accelerator (C) tends to suppress the activity of the branched imide resin (B), resulting in suppression of the increase in gelation time of a varnish and the increase in viscosity of the prepreg. Therefore, the phosphorus curing accelerator (C) can be used together with the branched imide resin (B) to also achieve the enhancement in preservation stability of a varnish and the enhancement in processability in prepreg preparation.

The content of the phosphorus curing accelerator (C) in the resin composition of the present embodiment is not particularly limited, but is preferably 0.1 to 10 parts by mass and more preferably 0.5 to 8 parts by mass based on 100 parts by mass of the total of the epoxy-modified silicone compound (A) and the branched imide resin (B) from the viewpoints of the light reflectance due to a heating treatment and a light irradiation treatment as well as the glass transition temperature.

The resin composition of the present embodiment contains the titanium dioxide (D) as an essential inorganic filling material. From the viewpoint of more increasing the light reflectance in an ultraviolet region and in a visible light region, titanium dioxide in which the crystal structure is a rutile or anatase structure is preferable.

The average particle size (D50) of the titanium dioxide (D) is not particularly limited, but is preferably 0.1 to 5 µm and more preferably 0.2 to 0.5 µm. The titanium dioxide (D) can be used singly or in appropriate combination of two or more. For example, it is also possible to use those having a different particle size distribution and a different average particle size in appropriate combination. The average particle size (D50) herein means the median diameter, which is the value at which the particle size distribution of a powder measured is divided to two areas and the area having larger particle sizes and the area having smaller particle sizes are the same in terms of the amount of particles. More specifically, the average particle size (D50) means the value at which the cumulative volume from smaller particles reaches 50% of the entire volume when the particle size distribution of a powder is measured by a wet laser diffraction scattering particle size distribution measuring apparatus.

From the viewpoint of still further increasing the light reflectance in an ultraviolet region and in a visible light region, the titanium dioxide (D) is herein preferably one subjected to a surface treatment with SiO₂, Al₂O₃, ZrO₂ and/or ZnO, in other words, one having a covering layer containing SiO₂, Al₂O₃, ZrO₂ and/or ZnO. Furthermore, the titanium dioxide (D) is more preferably one subjected to a surface treatment with SiO₂, Al₂O₃, ZrO₂ and/or ZnO and then subjected to a polyol treatment, a silane coupling agent treatment and/or an amine treatment, in other words, one having a covering layer containing SiO₂, Al₂O₃, ZrO₂ and/or ZnO and subjected to a polyol treatment, a silane coupling agent treatment and/or an amine treatment.

When the titanium dioxide (D) subjected to a surface treatment is used, preferably, SiO₂ is contained in an amount of 0.5 to 15 parts by mass, Al₂O₃ is contained in an amount of 0.5 to 15 parts by mass, ZrO₂ is contained in an amount of 0.5 to 15 parts by mass and/or ZnO is contained in an amount of 0.5 to 15 parts by mass, and more preferably, SiO₂ is contained in an amount of 1 to 11 parts by mass, Al₂O₃ is contained in an amount of 1 to 11 parts by mass, ZrO₂ is contained in an amount of 1 to 11 parts by mass and/or ZnO is contained in an amount of 1 to 11 parts by mass, based on 100 parts by mass of the total amount of the titanium dioxide (D). When surface-treated with such a preferable amount range, the discoloration due to a heating treatment or a light irradiation treatment tends to be more suppressed to further suppress the reduction in light reflectance without causing an excessive reduction in the light reflectance in an ultraviolet region and in a visible light region. The titanium dioxide (D) with 3 to 11 parts by mass of SiO₂ and 1 to 3 parts by mass of Al₂O₃ based on 100 parts by mass of the total amount of the titanium dioxide (D) is more preferable.

The content of the titanium dioxide (D) in the resin composition of the present embodiment is not particularly limited, but is preferably 10 to 300 parts by mass and more preferably 50 to 250 parts by mass based on 100 parts by mass of the total of the epoxy-modified silicone compound (A) and the branched imide resin (B). When the content is in such a preferable range, not only the occurrence of breaking, cracking, and the like due to conveyance and the like in production of a printed-wiring board and a chip LED tends to be suppressed without causing an excessive reduction in the light reflectance in an ultraviolet region and in a visible light region, but also the occurrence of the following failure tends to be suppressed: a drill bit and a dicing blade are broken and damaged and thus cannot be used in mechanical drill processing on a printed-wiring board and dicing processing on a chip LED.

The dispersant (E) for use in the resin composition of the present embodiment is not particularly limited, and a dispersion stabilizer generally used for paints can be suitably used. Preferably, a wet dispersant based on a copolymer is used. Specific examples thereof include polymer-based wetting dispersants produced by BYK Japan, for example, BYK-W903, BYK-W940, BYK-W996, BYK-W9010, Disper-BYK110, Disper-BYK111, Disper-BYK-110, 111, 161, and 180, but not particularly limited thereto. The dispersant (E) can be used singly or in appropriate combination of two or more.

The content of the dispersant (E) in the resin composition of the present embodiment is not particularly limited, but is preferably 0.05 to 10 parts by mass, more preferably 0.1 to 4.0 parts by mass, and further preferably 0.5 to 3.0 parts by mass based on 100 parts by mass of the total of the epoxy-modified silicone compound (A) and the branched imide resin (B). When the content of the dispersant (E) is in such a preferable range, heat resistance tends to be more increased and also the dispersibility of the resin and the titanium dioxide (D) in the resin composition tends to be more increased, suppressing variation in forming.

The resin composition of the present embodiment may contain, as an epoxy compound other than the above epoxy-modified silicone compound (A), a monomeric epoxy compound (F) having one or more epoxy rings. The monomeric epoxy compound (F) is not particularly limited in terms of the type thereof as long as it is a monomer having one or more epoxy rings, but is preferably a monomeric epoxy compound having one or two epoxy rings in one molecule from the viewpoint of being excellent in heat resistance and light discoloration resistance. When this monomeric epoxy compound (F) is used together with the epoxy-modified silicone compound (A), the branched imide resin (B), the titanium dioxide (D) and the dispersant (E), not only the viscosity of the prepreg tends to be reduced to improve prepreg-melting characteristics in heating, and the preservation stability of the prepreg and the formability of the metal foil-clad laminate tend to be still further enhanced, but also the glass transition temperature and the peel strength of the metal foil tend to be still further increased. In the resin composition of the present embodiment, while this monomeric epoxy compound (F) can be used together with the phosphorus curing accelerator (C), it can similarly serve as the phosphorus curing accelerator (C), and thus can also be used instead of the phosphorus curing accelerator (C).

The monomeric epoxy compound (F) is preferably any of compounds represented by the following formulae (8) to (10). Herein, the monomeric epoxy compound (F) can be used singly or in appropriate combination of two or more.

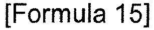

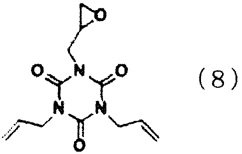

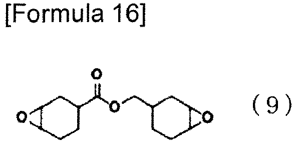

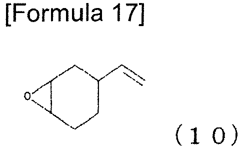

The molecular weight of the monomeric epoxy compound (F) is not particularly limited and can be appropriately set, but is preferably 80 to 800 and more preferably 120 to 500.

The monomeric epoxy compound (F) can be produced by a known method and a commercial product thereof is easily available. Examples of the compound represented by the formula (8) include DA-MGIC (produced by Shikoku Chemicals Corporation), examples of the compound represented by the formula (9) include Celloxide 2021 P (produced by Daicel Corporation), and examples of the compound represented by the formula (10) include Celloxide 2000 (produced by Daicel Corporation).

The content of the monomeric epoxy compound (F) in the resin composition of the present embodiment is not particularly limited, but is preferably 0.05 to 25 parts by mass, more preferably 0.1 to 20 parts by mass and further preferably 0.5 to 15 parts by mass based on 100 parts by mass of the total of the epoxy-modified silicone compound (A) and the branched imide resin (B) from the viewpoints of the preservation stability of the prepreg and the formability of the metal foil-clad laminate as well as the glass transition temperature and the peel strength of metal foil.

The epoxy equivalent of the monomeric epoxy compound (F) is not particularly limited, but is preferably 0.1 to 0.8 equivalents relative to the carboxyl residue of the branched imide resin (B) from the viewpoints of the enhancement in productivity and suppression of the increase in viscosity of the resin.

The resin composition of the present embodiment may also contain an alicyclic epoxy resin (G) as an epoxy compound other than the epoxy-modified silicone compound (A) and the monomeric epoxy compound (F). When this alicyclic epoxy resin (G) is used together with the epoxy-modified silicone compound (A), the branched imide resin (B), the phosphorus curing accelerator (C), the titanium dioxide (D) and the dispersant (E), in the light reflectance due to a heating treatment and a light irradiation treatment, and the glass transition temperature tend to be increased. This alicyclic epoxy resin (G) is preferably one obtained by ring-opening polymerization of an epoxy ring of an epoxy compound by an alcohol. Specific examples thereof include an alcohol adduct of vinylcyclohexene diepoxide, an alcohol adduct of 3,4-epoxycyclohexanecarboxylic acid-3',4'-epoxycyclohexylmethyl, an alcohol adduct of bis(3,4-epoxycyclohexylmethyl) adipate, an alcohol adduct of dicyclopentadiene diepoxide, an alcohol adduct of ε-caprolactone-modified bis(3,4-epoxycyclohexylmethyl)-4,5-epoxycyclohexane-1,2-dicarboxylic acid, an alcohol adduct of ε-caprolactone-modified tetra(3,4-epoxycyclohexylmethyl)butane-tetracarboxylic acid, an alcohol adduct of dipentene dioxide, an alcohol adduct of 1,4-cyclooctadiene diepoxide and an alcohol adduct of bis(2,3-epoxycyclopentyl)ether, but not particularly limited thereto. These can be used singly or in appropriate combination of two or more. Among them, a 2,2-bis(hydroxymethyl)-1-butanol adduct of vinylcyclohexene diepoxide is preferable from the viewpoints of heat resistance and light discoloration resistance.

The mass average molecular weight of the alicyclic epoxy resin (G) is not particularly limited and can be appropriately set, but is preferably 1500 to 10000 and more preferably 2000 to 7000.

The alicyclic epoxy resin (G) can be produced by a known method and a commercial product thereof is easily available. Examples of the commercial product include EHPE3150 (produced by Daicel Corporation) as the 2,2-bis(hydroxymethyl)-1-butanol adduct of vinylcyclohexene diepoxide.

The content of the alicyclic epoxy resin (G) in the resin composition of the present embodiment is not particularly limited, but is preferably 3 to 40 parts by mass, more preferably 5 to 30 parts by mass and further preferably 5 to 25 parts by mass based on 100 parts by mass of the total of the epoxy-modified silicone compound (A) and the branched imide resin (B) from the viewpoints of heat resistance and light discoloration resistance.

Herein, in the case where the resin composition of the present embodiment contains the monomeric epoxy compound (F) and/or the alicyclic epoxy resin (G), the preferable content of each of the components (A) to (G) in the resin composition of the present embodiment is as follows.

The content of the epoxy-modified silicone compound (A) in the resin composition is preferably 20 to 90 parts by mass and more preferably 30 to 80 parts by mass based on 100 parts by mass of the total of the epoxy-modified silicone compound (A), the branched imide resin (B), the monomeric epoxy compound (F) and the alicyclic epoxy resin (G) from the viewpoint of suppressing the discoloration of the resulting metal foil-clad laminate due to a heating treatment and a light irradiation treatment.

The content of the branched imide resin (B) in the resin composition is preferably 10 to 80 parts by mass, more preferably 15 to 70 parts by mass and further preferably 20 to 60 parts by mass based on 100 parts by mass of the total of the epoxy-modified silicone compound (A), the branched imide resin (B), the monomeric epoxy compound (F) and the alicyclic epoxy resin (G) from the viewpoints of increasing the peel strength and the heat resistance of the resulting metal foil-clad laminate and suppressing the discoloration of the resulting metal foil-clad laminate due to a heating treatment and a light irradiation treatment.

The content of the phosphorus curing accelerator (C) in the resin composition is preferably 0.1 to 10 parts by mass and more preferably 0.5 to 8 parts by mass based on 100 parts by mass of the total of the epoxy-modified silicone compound (A), the branched imide resin (B), the monomeric epoxy compound (F) and the alicyclic epoxy resin (G) from the viewpoints of the light reflectance due to a heating treatment and a light irradiation treatment and the glass transition temperature.

The content of the titanium dioxide (D) in the resin composition is preferably 10 to 400 parts by mass, more preferably 25 to 300 parts by mass and further preferably 100 to 250 parts by mass based on 100 parts by mass of the total of the epoxy-modified silicone compound (A), the branched imide resin (B), the monomeric epoxy compound (F) and the alicyclic epoxy resin (G) from the viewpoints of the light reflectance in an ultraviolet region and in a visible light region, formability and processability.

The content of the dispersant (E) in the resin composition is preferably 0.05 to 5 parts by mass, more preferably 0.1 to 4.0 parts by mass and further preferably 0.5 to 3.0 parts by mass based on 100 parts by mass of the total of the epoxy-modified silicone compound (A), the branched imide resin (B), the monomeric epoxy compound (F) and the alicyclic epoxy resin (G) from the viewpoints of heat resistance and dispersibility.

The content of the monomeric epoxy compound (F) in the resin composition is preferably 1 to 50 parts by mass, more preferably 0.5 to 20 parts by mass and further preferably 1.0 to 10 parts by mass based on 100 parts by mass of the total of the epoxy-modified silicone compound (A), the branched imide resin (B), the monomeric epoxy compound (F) and the alicyclic epoxy resin (G) from the viewpoints of the preservation stability of the prepreg and the formability of the metal foil-clad laminate as well as the glass transition temperature and the peel strength of metal foil.

The resin composition of the present embodiment may also further contain a silane coupling agent (H) if necessary. Since a silanol group in the silane coupling agent is particularly excellent in affinity for and reactivity with a material having a hydroxyl group on the surface thereof, the silanol group is effective for bonding of organic substance-inorganic substance, and improves the adhesiveness between a thermosetting resin and an inorganic filling material when the particle surface of the inorganic filling material reacts with the silane coupling agent. Therefore, use of the silane coupling agent (H) in combination tends to enhance the peel strength, the elastic modulus and the heat resistance after moisture absorption of the resulting metal foil-clad laminate, printed-wiring board and the like, as well as the outer appearance of a cured product. As the silane coupling agent (H) used herein, one generally used in a surface treatment of an inorganic substance can be suitably used and the type thereof is not particularly limited. Specific examples thereof include aminosilane-based agents such as γ-aminopropyl triethoxysilane and N-β-(aminoethyl)-γ-aminopropyl trimethoxysilane, epoxysilane-based agents such as γ-glycidoxypropyl trimethoxysilane, vinylsilane-based agents such as γ-methacryloxypropyl trimethoxysilane, cationic silane-based agents such as N-β-(N-vinylbenzylaminoethyl)-γ-aminopropyl trimethoxysilane hydrochloride, and phenylsilane-based agents. These can be used singly or in appropriate combination of two or more.

The content of the silane coupling agent (H) in the resin composition of the present embodiment can be appropriately set and is not particularly limited, but is preferably 0.5 to 8 parts by mass and more preferably 1 to 5 parts by mass based on 100 parts by mass of the total of the epoxy-modified silicone compound (A) and the branched imide resin (B) from the viewpoints of the adhesiveness between the resin and the inorganic filling material and the glass transition temperature.

Herein, the resin composition of the present embodiment may also contain an epoxy resin (hereinafter, simply also referred to as "other epoxy resin".) as an epoxy compound other than the epoxy-modified silicone compound (A), the monomeric epoxy compound (F) and the alicyclic epoxy resin (G). As such other epoxy resin, any known resin can be used as long as it is a compound having two or more epoxy groups in one molecule, and the type thereof is not particularly limited. Examples include a bisphenol A-based epoxy resin, a bisphenol E-based epoxy resin, a bisphenol F-based epoxy resin, a bisphenol S-based epoxy resin, a phenol novolac-based epoxy resin, a bisphenol A novolac-based epoxy resin, a cresol novolac-based epoxy resin, a biphenyl-based epoxy resin, a naphthalene-based epoxy resin, a trifunctional phenol-based epoxy resin, a tetrafunctional phenol-based epoxy resin, a glycidyl ester-based epoxy resin, a phenolaralkyl-based epoxy resin, a biphenylaralkyl-based epoxy resin, an aralkyl novolac-based epoxy resin, a naphthol aralkyl-based epoxy resin, a dicyclopentadiene-based epoxy resin, a polyol-based epoxy resin, an isocyanurate ring-containing epoxy, or halides thereof. Other epoxy resin can be used singly or in appropriate combination of two or more.

The resin composition of the present embodiment may also contain other inorganic filling material than the titanium dioxide (D), if necessary. As such other inorganic filling material, a material generally used in a laminate application can be suitably used, and examples thereof include silicas such as natural silica, synthetic silica, fused silica, amorphous silica, hollow silica and aerosil, white carbon, boehmite, molybdenum compounds such as molybdenum oxide and zinc molybdate, metal hydrates such as zinc borate, zinc stannate, boron nitride, aggregated boron nitride, silicon nitride, aluminum nitride, barium sulfate, aluminum hydroxide, aluminum hydroxide subjected to heat treatment (obtained by subjecting aluminum hydroxide to heat treatment to partially reduce crystal water) and magnesium hydroxide, zinc oxide, magnesium oxide, zirconium oxide, aluminum hydroxide, boron nitride, alumina, clay, kaolin, talc, fired clay, fired kaolin, fired talc, mica, E-glass, A-glass, NE-glass, C-glass, L-glass, D-glass, S-glass, M-glass G20, short glass fibers (including fine powders of glasses such as E glass, T glass, D glass, S glass and Q glass.), hollow glass, and spherical glass, but not particularly limited thereto. Among them, as other inorganic filling material, silicas and talc are preferable from the viewpoints of suppressing an excessive reduction in light reflectance and also improving laminate characteristics such as rate of thermal expansion, and silicas are more preferable from the viewpoint of electrical characteristics. Other inorganic filling material listed here can be used singly or in appropriate combination of two or more. The average particle size (D50) of other inorganic filling material is not particularly limited, but is preferably 0.1 to 5 µm and particularly preferably 0.2 to 3 µm in consideration of dispersibility, flow characteristics in forming, and breaking and damaging in use of a small-diameter drill bit. The content of such other inorganic filling material is not particularly limited, but is preferably 1 to 300 parts by mass and more preferably 5 to 250 parts by mass or less based on 100 parts by mass of the total of the epoxy-modified silicone compound (A) and the branched imide resin (B).

Furthermore, the resin composition of the present embodiment may also contain a curing accelerator other than the phosphorus curing accelerator (C), if necessary. The curing accelerator is not particularly limited in terms of the type thereof as long as it is one known in the art and generally used. Examples of the curing accelerator include organic metal salts of copper, zinc, cobalt, nickel, manganese and the like, imidazoles and derivatives thereof, and tertiary amines. Herein, the content of the curing accelerator can be appropriately set and is not particularly limited, but is usually preferably about 0.01 to 15 parts by mass and more preferably 0.02 to 3 parts by mass based on 100 parts by mass of the total of the epoxy-modified silicone compound (A), the branched imide resin (B), the monomeric epoxy compound (F) and the alicyclic epoxy resin (G) from the viewpoints of the degree of curing of the resin, the viscosity of the resin composition, and the like.

The resin composition of the present embodiment may also contain other component than the above components as long as the desired characteristics are not impaired. Examples of such optional blending material include a thermosetting resin other than the above thermosetting resins, a thermoplastic resin, various polymer compounds thereof such as oligomers and elastomers thereof, a flame retardant compound, and various additives. These are not particularly limited as long as these are generally used in the art. Examples of the flame retardant compound include bromine compounds such as 4,4'-dibromobiphenyl, phosphorus compounds such as phosphate, melamine phosphate and a phosphorus-containing epoxy resin, nitrogen-containing compounds such as melamine and benzoguanamine, and an oxazine ring-containing compound. Specific examples of the additives include an ultraviolet absorber, an antioxidant, a photopolymerization initiator, a fluorescent whitener, a photosensitizer, a dye, a pigment, a thickener, a lubricant, an antifoamer, a dispersant, a leveling agent, a gloss agent, and a polymerization inhibitor. Such an optional blending material can be used singly or in appropriate combination of two or more.

In addition, the resin composition of the present embodiment may further contain a solvent if necessary. For example, when an organic solvent is used, the viscosity of the resin composition in preparation can be lowered, resulting in the enhancement in handling properties and the improvement in impregnating properties in a glass cloth. The type of the solvent is not particularly limited as long as the mixture of the epoxy-modified silicone compound (A) and the branched imide resin (B) can be dissolved in or be compatible with the solvent. Specific examples thereof include ketones such as acetone, methyl ethyl ketone, methyl isobutyl ketone and cyclohexanone, aromatic hydrocarbons such as benzene, toluene and xylene, amides such as dimethylformamide and dimethylacetamide, and propylene glycol methyl ether and acetate thereof, but not particularly limited thereto. The solvent can be used singly or in appropriate combination of two or more.

The resin composition of the present embodiment can be prepared according to an ordinary method, and the preparation method is not particularly limited as long as it is a method that can provide a resin composition uniformly containing the epoxy-modified silicone compound (A), the branched imide resin (B), the phosphorus curing accelerator (C), the titanium dioxide (D) and the dispersant (E), as well as the other optional components. For example, the resin composition of the present embodiment can be easily prepared by sequentially blending the epoxy-modified silicone compound (A), the branched imide resin (B), the phosphorus curing accelerator (C), the titanium dioxide (D) and the dispersant (E) in a solvent and sufficiently stirring them.

When the resin composition of the present embodiment is prepared, an organic solvent can be used if necessary. The type of the organic solvent is not particularly limited as long as the mixture of the epoxy-modified silicone resin (A) and the branched imide resin (B) can be dissolved in or be compatible with the solvent. Specific examples thereof are as described above.

When the resin composition of the present embodiment is prepared, a known treatment for uniformly dissolving or dispersing the respective components (stirring, mixing and kneading treatment, and the like) can be performed. For example, a stirring tank provided with a proper stirring machine having stirring ability is used to perform a stirring/dispersing treatment as a measure of stirring/dispersing the titanium dioxide (D) in the resin composition, thereby resulting in the improvement in dispersibility of the titanium dioxide (D) in the resin composition. The stirring, mixing and kneading treatment can be appropriately performed by using, for example, an apparatus for mixing, such as a ball mill and a bead mill, or a known apparatus such as a planetary centrifugal mixing apparatus.

In the preparation of the resin composition of the present embodiment, when at least the branched imide resin (B), the phosphorus curing accelerator (C) and the monomeric epoxy compound (F) are dissolved in the solvent and subjected to a pretreatment with reflux at the boiling point of the solvent, the increase in molecular weight of the resulting resin composition can be controlled to suppress an excessive increase in viscosity. For example, the branched imide resin (B) having an isocyanurate ring and a carboxyl group, the monomeric epoxy compound (C) and the phosphorus curing accelerator (F) can be dissolved in propylene glycol methyl ether in a nitrogen atmosphere at ordinary pressure and subjected to a pretreatment with reflux at the boiling point (150°C) of propylene glycol methyl ether for 4 hours. The solvent for use in the pretreatment is not particularly limited, but examples thereof include aromatic hydrocarbons such as toluene and xylene, amides such as dimethylformamide, and propylene glycol methyl ether and acetate thereof. These can be used singly or in appropriate combination of two or more.

A prepreg of the present embodiment can be obtained by combining the resin composition with a substrate, specifically, impregnating or coating a substrate with the resin composition. The method for preparing the prepreg can be performed according to an ordinary method, and is not particularly limited. For example, a substrate can be impregnated or coated with the resin composition containing the epoxy-modified silicone compound (A), the branched imide resin (B), the phosphorus curing accelerator (C), the titanium dioxide (D) and the dispersant (E), and then, for example, heated in a dryer at 100 to 200°C for 1 to 30 minutes for semi-curing (B-staging) to thereby produce the prepreg of the present embodiment. In the prepreg of the present embodiment, the amount of the resin composition (including the titanium dioxide (D) and other inorganic filling material) based on the total amount of the prepreg is preferably in a range from 30 to 90% by mass, but not particularly limited thereto.

The substrate for use in the prepreg of the present embodiment is not particularly limited, and known one used for various printed-wiring board materials can be appropriately selected depending on the intended use and performance, and used. Specific examples thereof include glass fibers such as E glass, D glass, L glass, S glass, Q glass, spherical glass, NE glass and T glass, inorganic fibers other than glass, such as quartz and barium titanate, organic fibers such as polyimide, polyamide and polyester, and woven fabrics such as liquid crystal polyester, but not particularly limited thereto. The substrate can be used singly or in appropriate combination of two or more. As the form of the substrate, a woven fabric, a nonwoven fabric, a roving, a chopped strand mat, a surfacing mat, and the like are known, as the weave of the woven fabric, plain weave, mat weave, twill weave, and the like are known, and any form and any weave can be appropriately adopted. The substrate can be used singly or in appropriate combination of two or more. In particular, a glass woven fabric subjected to a super opening treatment or a glass woven fabric subjected to a clogging treatment is suitably used from the viewpoint of dimensional stability. A glass woven fabric subjected to a surface treatment with a silane coupling agent or the like, such as an epoxysilane treatment or an aminosilane treatment, is preferable from the viewpoint of heat resistance after moisture absorption. A liquid crystal polyester woven fabric is preferable from the viewpoint of electrical characteristics. The thickness and the mass of the substrate are not particularly limited, but one having a thickness of about 0.01 to 0.3 mm is usually suitably used. In particular, the substrate is preferably a glass woven fabric having a thickness of 200 µm or less and a mass of 250 g/m² or less, and more preferably a glass woven fabric made of glass fibers of E glass, from the viewpoints of strength and water absorption property. The substrate is used in preparation of the prepreg.

A metal foil-clad laminate of the present embodiment is obtained by stacking at least one or more sheets of the prepreg, disposing metal foil on one or both surfaces of the resultant, and lamination-forming. Specifically, the metal foil-clad laminate of the present embodiment can be prepared by stacking one sheet or a plurality of sheets of the prepreg, disposing metal foil such as copper or aluminum foil on one or both surfaces of the resultant, and lamination-forming. The metal foil for use here is not particularly limited as long as it is used for a printed-wiring board material, but copper foil such as rolled copper foil or electrolytic copper foil is preferable. In consideration of a conductor loss in a high frequency region, electrolytic copper foil having small mat surface roughness is more preferable. The thickness of the metal foil is not particularly limited, but is preferably 2 to 70 µm and more preferably 2 to 35 µm. The method for forming the metal foil-clad laminate and the forming conditions are not also particularly limited, and a general procedure and conditions for laminates for printed-wiring boards, and multi-layer plates can be applied. For example, when the metal foil-clad laminate is formed, a multistage pressing machine, a multistage vacuum pressing machine, a continuous forming machine, an autoclave forming machine, or the like can be used, and the temperature is generally in a range from 100 to 300°C, the pressure is generally in a range from 2 to 100 kgf/cm² as surface pressure and the heating time is generally in a range from 0.05 to 5 hours. Furthermore, post-curing can also be performed at a temperature of 150 to 300°C, if necessary. In addition, the prepreg of the present embodiment and a wiring board separately prepared for an inner layer can also be combined for lamination forming to thereby provide a multi-layer plate. As the method for producing the multi-layer plate, for example, a method is known in which 35 µm copper foil is disposed on each of both surfaces of one sheet of the prepreg, the resultant is subjected to lamination forming under the above conditions, an inner layer circuit is then formed and the circuit is subjected to a blackening treatment to form an inner layer circuit board, thereafter this inner layer circuit board and the prepreg are alternately disposed one by one, copper foil is disposed on the outermost layer, and the resultant is subjected to lamination forming under the above conditions preferably in vacuum.

Then, the metal foil-clad laminate of the present embodiment not only is excellent in heat resistance, but also has a high light reflectance in an ultraviolet region and in a visible light region, causes a small reduction in light reflectance due to a heating treatment and a light irradiation treatment, further is also excellent in peel strength of metal foil, and furthermore is also excellent in heat resistance after moisture absorption in a preferable mode. Therefore, the metal foil-clad laminate of the present embodiment can be significantly effectively used for a printed-wiring board that is demanded to have such performances, in particular, an LED-mounting printed-wiring board.

The metal foil-clad laminate of the present embodiment, on which a predetermined wiring pattern is formed, can be thus suitably used as a printed-wiring board. A printed-wiring board can be produced according to an ordinary method and the production method thereof is not particularly limited. One example of a method for producing a printed-wiring board is shown as follows. First, the metal foil-clad laminate such as the copper-clad laminate is prepared. Then, the surface of the metal foil-clad laminate is subjected to an etching treatment to form an inner layer circuit, preparing an inner layer plate. The inner layer circuit surface of this inner layer plate is if necessary subjected to a surface treatment for the increase in adhesion strength, then a predetermined number of sheets of the prepreg is stacked on the inner layer circuit surface, and metal foil for an outer layer circuit is further laminated on the outer surface of the resultant, and heated and pressurized for integral forming. Thus, a multi-layer laminate is produced in which an insulation layer made of the substrate and the cured product of the thermosetting resin composition is formed between the inner layer circuit and the metal foil for an outer layer circuit. Then, this multi-layer laminate is subjected to drilling for a through hole or a via hole, thereafter a plating metal film for conducting the inner layer circuit with the metal foil for an outer layer circuit is formed on the wall surface of this hole, and furthermore the metal foil for an outer layer circuit is subjected to an etching treatment to form an outer layer circuit, thereby producing a printed-wiring board.

The printed-wiring board obtained by the production example has a configuration having an insulation layer and a conductor layer formed on the surface of this insulation layer, the insulation layer including the resin composition of the present embodiment. That is, the prepreg of the present embodiment (the substrate, and the resin composition of the present embodiment with which the substrate is impregnated or coated), and the layer of the resin composition in the metal foil-clad laminate of the present embodiment (the layer made of the resin composition of the present embodiment) are each configured from the insulation layer including the resin composition of the present embodiment.

### Examples

Hereinafter, the present invention will be described in detail with reference to Examples and Comparative Examples, but the present invention is not limited to these Examples at all. Hereinafter, "part(s)" means "part(s) by mass" unless otherwise noticed.

### (Example 1)

Fifty-five parts by mass of an aliphatic epoxy-modified silicone compound represented by the following formula (11) (X-40-2670 (produced by Shin-Etsu Chemical Co., Ltd.)), 45 parts by mass of an epoxy-modified branched imide compound having a mass average molecular weight (Mw) of 33000 (ELG-941 (acid value: 35 mgKOH/g) produced by Dic Corporation), 5 parts by mass of methyltributylphosphonium dimethyl phosphate (PX-4MP (produced by Nippon Chemical Industrial Co., Ltd.)) as a phosphorus curing accelerator, 200 parts by mass of titanium dioxide (CR90 (surface-treated with 1 to 5 parts by mass of SiO₂ and 1 to 3 parts by mass of Al₂O₃ based on 100 parts by mass of the total of the titanium dioxide) produced by Ishihara Sangyo Kaisha, Ltd.), 1.75 parts by mass of a wet dispersant (BYK-W903 produced by BYK Japan) and 3 parts by mass of a silane coupling agent (Z6040 produced by Dow Corning Toray Co., Ltd.) were stirred and mixed in a homomixer to provide a varnish. This varnish was diluted using methyl ethyl ketone by two-fold on the mass basis, an E glass cloth having a thickness of 0.08 mm was impregnated with the diluted varnish, and the resultant was heated at 150°C for 3 minutes to provide a prepreg having a resin composition in an amount of 48% by mass. Then, two sheets of this prepreg were stacked, electrolytic copper foil having a thickness of 12 µm (JTC-LPZ foil manufactured by JX Nippon Mining & Metals Corporation) was disposed on each of the upper and lower surfaces of the resulting laminated body, and thereafter the resultant was subjected to pressure-forming using a vacuum pressing machine under a vacuum of 30 mmHg or less at a temperature of 220°C and a surface pressure of 30 kgf/cm² for 150 minutes, thereby providing a both-surface copper foil-clad laminate having a thickness of about 0.2 mm.

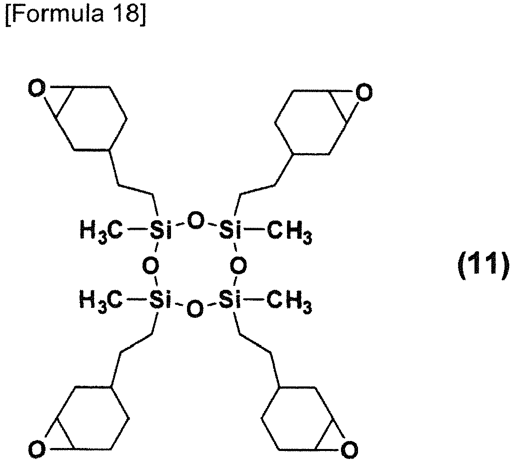

### (Example 2)

The same manner as in Example 1 was performed to thereby prepare a varnish, providing a prepreg and a both-surface copper foil-clad laminate, except that the amount of the epoxy-modified silicone compound blended and the amount of the epoxy-modified branched imide compound blended were changed to 45 parts by mass and 55 parts by mass, respectively.

### (Example 3)

The same manner as in Example 2 was performed to thereby prepare a varnish, providing a prepreg and a both-surface copper foil-clad laminate, except that the amount of the epoxy-modified silicone compound blended and the amount of the epoxy-modified branched imide compound blended were changed to 55 parts by mass and 35 parts by mass, respectively, and 10 parts by mass of a 1,2-epoxy-4-(2-oxiranyl)cyclohexane adduct of 2,2-bis(hydroxymethyl)-1-butanol (EHPE-3150 produced by Daicel Corporation) was further blended as an alicyclic epoxy resin.

### (Example 4)

The same manner as in Example 1 was performed to thereby prepare a varnish, providing a prepreg and a both-surface copper foil-clad laminate, except that 25 parts by mass of an amine-modified branched imide compound having a mass average molecular weight (Mw) of 4800 (ELG-1301 (acid value: 120 mgKOH/g) produced by Dic Corporation) was used instead of the epoxy-modified branched imide compound, and 20 parts by mass of the alicyclic epoxy resin used in Example 3 was further blended as an epoxy resin.

### (Example 5)

The same manner as in Example 4 was performed to thereby prepare a varnish, providing a prepreg and a both-surface copper foil-clad laminate, except that 25 parts by mass of an alcohol-modified branched imide compound having a mass average molecular weight (Mw) of 3500 (ELG-1302 (acid value: 70.8 mgKOH/g) produced by Dic Corporation) was used instead of the amine-modified branched imide compound.

### (Comparative Example 1)

The same manner as in Example 1 was performed to thereby prepare a varnish, providing a prepreg and a both-surface copper foil-clad laminate, except that 45 parts by mass of a non-modified, multi-branched imide compound having a mass average molecular weight of 11000 ((V-8002 (acid value: 127 mgKOH/g) produced by Dic Corporation) was used instead of the epoxy-modified branched imide compound and blending of the phosphorus curing accelerator was omitted.

### (Comparative Example 2)

The same manner as in Comparative Example 1 was performed to thereby prepare a varnish, providing a prepreg and a both-surface copper foil-clad laminate, except that 45 parts by mass of the epoxy-modified branched imide compound used in Example 1 was used instead of the non-modified, branched imide compound.

### (Comparative Example 3)

The same manner as in Comparative Example 2 was performed to thereby prepare a varnish, providing a prepreg and a both-surface copper foil-clad laminate, except that 1 part by mass of an aluminum-based curing accelerator (ALCH-TR (produced by Kawaken Fine Chemicals Co., Ltd.)) was further blended.

### (Comparative Example 4)

The same manner as in Comparative Example 3 was performed to thereby prepare a varnish, providing a prepreg and a both-surface copper foil-clad laminate, except that 1 part by mass of a cationic curing accelerator (Saneid-SI-150L (produced by Sanshin Chemical Industry Co., Ltd.)) was used instead of the aluminum-based curing accelerator (ALCH-TR (produced by Kawaken Fine Chemicals Co., Ltd.)).

The prepreg obtained as described above in each of Examples 1 to 5 and Comparative Examples 1 to 4 was used to evaluate the outer appearance and the preservation stability of the prepreg. In addition, the both-surface copper foil-clad laminate obtained as described above in each of Examples 1 to 5 and Comparative Examples 1 to 4 was used to measure and evaluate the inner appearance and the outer appearance of the laminate, the reflectance, the reflectance after heating, the reflectance after a light treatment, the Tg, the peel strength, and the solder heat resistance after moisture absorption.

Herein, measurement methods and evaluation methods for each test are as follows.

### (Measurement methods and evaluation methods)

1) Outer appearance of prepreg: the tackiness of the surface of the resulting prepreg was checked by finger touch. Herein, one good in tackiness and usable as a product was rated "○", and one poor in tackiness and unusable as a product was rated as "Tackiness".
2) Preservation stability: the resulting prepreg was subjected to a heating treatment by a hot air dryer at 40°C for 120 hours. Two sheets of this prepreg subjected to a heating treatment were stacked, electrolytic copper foil having a thickness of 12 µm (JTC-LPZ foil manufactured by JX Nippon Mining & Metals Corporation) was disposed on each of the upper and lower surfaces of the resulting laminated body, and the resultant was subjected to pressure-forming using a vacuum pressing machine under a vacuum of 30 mmHg or less at a temperature of 220°C and a surface pressure of 30 kgf/cm² for 150 minutes, aiming to prepare a both-surface copper-clad laminate having a thickness of 0.2 mm. Then, one good in flowing of the resin composition was rated as "○", and one poor in flowing of the resin composition and having variation in curing found thereon was rated as "Variation in curing".
3) Inner appearance and outer appearance of copper-clad laminate: the resulting both-surface copper-clad laminate was cut by dicing saw to a size of 50 × 50 mm, the copper foil on the surface was removed by etching, and thereafter the resultant was polished using a polishing machine to provide a measurement sample in which the cross section of the both-surface copper-clad laminate was exposed. The outer appearance of the measurement sample was visually observed and the cross section of the measurement sample was observed by SEM using an optical microscope. A case where lack of the resin was not observed was rated as "○", and a case where lack of the resin was observed was rated as "×".
4) Reflectance: the resulting both-surface copper foil-clad laminate was cut by dicing saw to a size of 50 × 50 mm, and thereafter the copper foil on the surface was removed by etching to provide a measurement sample. This measurement sample was used to measure the reflectance at 457 nm using a spectrophotometer (manufactured by Konica Minolta Inc.: CM3610d) according to JIS Z-8722 (average value for n = 5).
5) Reflectance after heating: the sample obtained in 4) was subjected to a heating treatment by a hot air dryer at 180°C for 24 hours, and thereafter the reflectance was measured in the same manner as in the measurement of the reflectance in 4) (average value for n = 5).
6) Reflectance after heating and light irradiation: the sample obtained in 4) was subjected to a heating and light irradiation treatment (ultraviolet irradiation intensity: 100 mW/cm²) on a hot plate at 180°C installed in a weather meter and dryer (SUV-F11 manufactured by Iwasaki Electric Co., Ltd.) at an ultraviolet (wavelength: 295 to 450 nm) irradiation intensity of 100 mW/cm² for 24 hours, and thereafter the reflectance was measured in the same manner as in the measurement of the reflectance in 4) (average value for n = 5).
7) Tg: the resulting both-surface copper foil-clad laminate was cut by dicing saw to a size of 12.7 × 2.5 mm, and thereafter the copper foil on the surface was removed by etching to provide a measurement sample. This measurement sample was used to measure the glass transition temperature with a dynamic viscoelasticity analyzer (manufactured by TA Instruments) by the DMA method according to JIS C6481 (average value for n = 3).
8) Peel strength: the resulting both-surface copper foil-clad laminate was cut by dicing saw to a size of 10 × 100 mm, and thereafter a measurement sample in which the copper foil on the surface remained was obtained. According to a test method of a copper-clad laminate for a printed-wiring board defined in JIS C6481 (see 5.7 peeling strength.), Autograph (manufactured by Shimadzu Corporation: AG-IS) was used to measure the peeling strength of the copper foil of the measurement sample (average value for n = 5).
9) Solder heat resistance after moisture absorption: the resulting both-surface copper foil-clad laminate was cut by dicing saw to a size of 50 mm × 50 mm, and thereafter 3/4 of the copper foil on the surface was removed by etching to provide a measurement sample. This measurement sample was used, and the change in outer appearance thereof after the sample was subjected to moisture absorption in a pressure cooker tester PCT (120°C/2 atm) for 3 hours and then immersed in a solder tank at 260°C for 1 minute was visually observed. This test was performed three times, and a case where no defects were found in all three tests was rated as "No defects: (○)", and a case where swelling occurred even in one test was rated as "Swelling occurred: (×)".

The evaluation results are shown in Tables 1 and 2.

**[Table 1]**

| | | Example 1 | Example 2 | Example 3 | Example 4 | Example 5 |
|---|---|---|---|---|---|---|
| Characteristics of prepreg | Outer appearance | ○ | ○ | ○ | ○ | ○ |
| | Preservation stability | ○ | ○ | ○ | ○ | ○ |
| Characteristics of copper-clad laminate | Inner appearance and outer appearance | ○ | ○ | ○ | ○ | ○ |
| | Reflectance (%) | 90 | 89 | 90 | 90 | 90 |
| | Reflectance after heating (%) | 80 | 80 | 80 | 80 | 80 |
| | Reflectance after heating and light irradiation (%) | 75 | 75 | 75 | 75 | 75 |
| | Tg(°C) | 170 | 183 | 182 | 182 | 182 |
| | Peel strength (gf/cm) | 650 | 700 | 650 | 650 | 650 |
| | Solder heat resistance after moisture absorption | ○ | ○ | ○ | ○ | ○ |

**[Table 2]**

| | | Comparative Example 1 | Comparative Example 2 | Comparative Example 3 | Comparative Example 4 |
|---|---|---|---|---|---|
| Characteristics of prepreg | Inner appearance and outer appearance | ○ | Tackiness | ○ | ○ |
| | Preservation stability | × | ○ | × | × |
| Characteristics of copper-clad laminate | Inner appearance and outer appearance | ○ | ○ | Variation in curing | Variation in curing |
| | Reflectance (%) | 91 | 91 | 90 | 87 |
| | Reflectance after heating (%) | 81 | 73 | 85 | 81 |
| | Reflectance after heating and light irradiation (%) | 75 | 70 | 75 | 70 |
| | Tg(°C) | 184 | 110 | 171 | 193 |
| | Peel strength (gf/cm) | 700 | 200 | 350 | 400 |
| | Solder heat resistance after moisture absorption | ○ | × | × | × |

### (Example 6)

Fifty-five parts by mass of an aliphatic epoxy-modified silicone compound (X-40-2670 produced by Shin-Etsu Chemical Co., Ltd.), 20 parts by mass of an alcohol-modified multi-branched imide resin having a mass average molecular weight (Mw) of 3500 (ELG-1302 produced by Dic Corporation, acid value: 70.8 mgKOH/g), 5 parts by mass of a monomeric epoxy compound represented by the following formula (8) (DA-MGIC produced by Shikoku Chemicals Corporation), 20 parts by mass of a 2,2-bis(hydroxymethyl)-1-butanol adduct of vinylcyclohexene diepoxide (EHPE3150 produced by Daicel Corporation) as an alicyclic epoxy resin, 3 parts by mass of methyltributylphosphonium dimethyl phosphate (PX-4MP produced by Nippon Chemical Industrial Co., Ltd.) as a phosphorus curing accelerator, 180 parts by mass of titanium dioxide (CR90 (surface-treated with 1 to 5 parts by mass of SiO₂ and 1 to 3 parts by mass of Al₂O₃ based on 100 parts by mass of the total of the titanium dioxide) produced by Ishihara Sangyo Kaisha Ltd.), 1.75 parts by mass of a wet dispersant (BYK-W903 produced by BYK Japan) and 3 parts by mass of a silane coupling agent (Z6040 produced by Dow Corning Toray Co., Ltd.) were stirred and mixed in a homomixer to provide a varnish. This varnish was diluted using methyl ethyl ketone by two-fold on the mass basis, an E glass cloth having a thickness of 0.08 mm was impregnated with the diluted varnish, and the resultant was heated at 150°C for 3 minutes to provide a prepreg having a resin composition in an amount of 50% by mass. Then, two sheets of this prepreg were stacked, electrolytic copper foil having a thickness of 12 µm (JTC-LPZ foil manufactured by JX Nippon Mining & Metals Corporation) was disposed on each of the upper and lower surfaces of the resulting laminate, and thereafter the resultant was subjected to pressure-forming using a vacuum pressing machine under a vacuum of 30 mmHg or less at a temperature of 230°C and a surface pressure of 35 kgf/cm² for 150 minutes, thereby providing a both-surface copper foil-clad laminate having a thickness of about 0.2 mm.

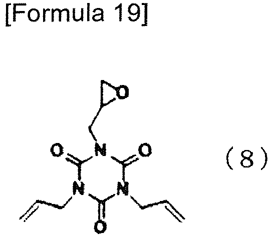

### (Example 7)

The same manner as in Example 6 was performed to thereby prepare a varnish, providing a prepreg and a both-surface copper foil-clad laminate, except that the amount of the monomeric epoxy compound (DA-MGIC produced by Shikoku Chemicals Corporation) blended, the amount of the alicyclic epoxy resin (EHPE3150 produced by Daicel Corporation) blended and the amount of the titanium dioxide (CR90 produced by Ishihara Sangyo Kaisha Ltd.) blended were changed to 7.5 parts by mass, 17.5 parts by mass and 200 parts by mass, respectively.

### (Example 8)

The same manner as in Example 6 was performed to thereby prepare a varnish, providing a prepreg and a both-surface copper-clad laminate, except that 5 parts by mass of Celloxide 2021 P represented by the following formula (9) (produced by Daicel Corporation) was used instead of the monomeric epoxy compound (DA-MGIC produced by Shikoku Chemicals Corporation), and the amount of the titanium dioxide (CR90 produced by Ishihara Sangyo Kaisha Ltd.) blended was changed to 200 parts by mass.

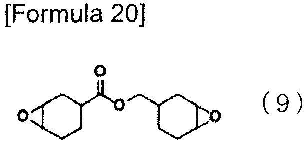

### (Example 9)

The same manner as in Example 8 was performed to thereby prepare a varnish, providing a prepreg and a both-surface copper-clad laminate, except that the amount of the alicyclic epoxy resin (EHPE3150 produced by Daicel Corporation) blended and the amount of the monomeric epoxy compound (Celloxide 2021 P) blended were changed to 19 parts by mass and 1 part by mass, respectively.

### (Example 10)

Twenty-seven parts by mass of a multi-branched imide resin having a mass average molecular weight (Mw) of 3500 (ELG-1302 produced by Dic Corporation, acid value: 70.8 mgKOH/g), 3 parts by mass of a monomeric epoxy compound represented by the following formula (10) (Celloxide 2000 produced by Daicel Corporation) and 3 parts by mass of methyltributylphosphonium dimethyl phosphate (PX-4MP (produced by Nippon Chemical Industrial Co., Ltd.) as a phosphorus curing accelerator were subjected to a pretreatment with reflux in the presence of a solvent, and thereafter 55 parts by mass of an aliphatic epoxy-modified silicone compound (X-40-2670 produced by Shin-Etsu Chemical Co., Ltd.), 15 parts by mass of a 2,2-bis(hydroxymethyl)-1-butanol adduct of vinylcyclohexene diepoxide (EHPE3150 produced by Daicel Corporation) as an alicyclic epoxy compound, 180 parts by mass of titanium dioxide (CR90 (surface-treated with 1 to 5 parts by mass of SiO₂ and 1 to 3 parts by mass of Al₂O₃ based on 100 parts by mass of the total of the titanium dioxide) produced by Ishihara Sangyo Kaisha Ltd.), 1.75 parts by mass of a wet dispersant (BYK-W903 produced by BYK Japan) and 3 parts by mass of a silane coupling agent (Z6040 produced by Dow Corning Toray Co., Ltd.) were stirred and mixed therewith in a homomixer to provide a varnish.

The same manner as in Example 6 was performed to thereby provide a prepreg and a both-surface copper-clad laminate, except that the varnish thus obtained was used.

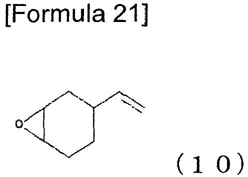

### (Comparative Example 5)

Fifty-five parts by mass of an aliphatic epoxy-modified silicone compound (X-40-2670 (produced by Shin-Etsu Chemical Co., Ltd.)), 45 parts by mass of an epoxy-modified branched imide compound having a mass average molecular weight of 11000 (V-8002 produced by Dic Corporation, acid value: 127 mgKOH/g), 200 parts by mass of titanium dioxide (CR90 produced by Ishihara Sangyo Kaisha Ltd.), 1.75 parts by mass of a wet dispersant (BYK-W903 produced by BYK Japan) and 3 parts by mass of a silane coupling agent (Z6040 produced by Dow Corning Toray Co., Ltd.) were stirred and mixed in a homomixer to provide a varnish. The same manner as in Example 6 was performed to thereby provide a prepreg and a both-surface copper foil-clad laminate having a thickness of 0.2 mm, except that this varnish was used.

### (Comparative Example 6)

Fifty-five parts by mass of an aliphatic epoxy-modified silicone compound (X-40-2670 produced by Shin-Etsu Chemical Co., Ltd.), 20 parts by mass of a non-modified, multi-branched imide resin having a mass average molecular weight (Mw) of 4800 (ELG-1224 produced by Dic Corporation, acid value: 90.0 mgKOH/g), 25 parts by mass of a 2,2-bis(hydroxymethyl)-1-butanol adduct of vinylcyclohexene diepoxide (EHPE3150 produced by Daicel Corporation) as an alicyclic epoxy resin, 180 parts by mass of titanium dioxide (CR90 (surface-treated with 1 to 5 parts by mass of SiO₂ and 1 to 3 parts by mass of Al₂O₃ based on 100 parts by mass of the total of the titanium dioxide) produced by Ishihara Sangyo Kaisha Ltd.), 1.75 parts by mass of a wet dispersant (BYK-W903 produced by BYK Japan) and 3 parts by mass of a silane coupling agent (Z6040 produced by Dow Corning Toray Co., Ltd.) were stirred and mixed in a homomixer to provide a varnish. The same manner as in Example 6 was performed to thereby provide a prepreg and a both-surface copper foil-clad laminate, except that this varnish was used.

The prepreg obtained as described above in each of Examples 6 to 10 and Comparative Examples 5 to 6 was used to evaluate the outer appearance of the prepreg, and the viscosity and the preservation stability of the prepreg. In addition, the both-surface copper foil-clad laminate obtained as described above in each of Examples 6 to 10 and Comparative Examples 5 to 6 was used to evaluate the outer appearance of the copper-clad laminate, the reflectance, the reflectance after heating, the reflectance after a light treatment, the Tg, the peel strength, and the solder heat resistance after moisture absorption.

Herein, measurement methods and evaluation methods for each test are as follows.

### (Measurement methods and evaluation methods)

1) Outer appearance of prepreg: the tackiness of the surface of the resulting prepreg was checked by finger touch. Herein, one good in tackiness and usable as a product was rated "○", and one poor in tackiness and unusable as a product was rated as "Tackiness".
2) Viscosity of prepreg: the viscosity of the resulting prepreg was measured using a flow tester (manufactured by Shimadzu Corporation: CFT-500D). Measurement conditions were as follows: heater temperature: 120°C; diameter of die hole: 1.0 mm; length of die hole: 1.0 mm; cross-sectional area of piston: 1cm²; and load: 0.5 kg.
3) Preservation stability: the resulting prepreg was subjected to a heating treatment by a hot air dryer at 40°C for 120 hours. Two sheets of this prepreg subjected to a heating treatment were stacked, electrolytic copper foil having a thickness of 12 µm (JTC-LPZ foil manufactured by JX Nippon Mining & Metals Corporation) was disposed on each of the upper and lower surfaces of the resulting laminated body, and the resultant was subjected to pressure-forming using a vacuum pressing machine under a vacuum of 30 mmHg or less at a temperature of 220°C and a surface pressure of 30 kgf/cm² for 150 minutes, aiming to prepare a both-surface copper-clad laminate having a thickness of 0.2 mm. Then, one good in flowing of the resin composition was rated as "○", and one poor in flowing of the resin composition and having variation in curing found thereon was rated as "Variation in curing".
4) Inner appearance of copper-clad laminate: the resulting both-surface copper-clad laminate was cut by dicing saw to a size of 50 × 50 mm, the copper foil on the surface was removed by etching, and thereafter the resultant was polished using a polishing machine to provide a measurement sample in which the cross section of the both-surface copper-clad laminate was exposed. The cross section of the measurement sample was observed by SEM using an optical microscope. A case where lack of the resin was not observed was rated as "○", and a case where lack of the resin was observed was rated as "×".
5) Reflectance: the resulting both-surface copper foil-clad laminate was cut by dicing saw to a size of 50 × 50 mm, and thereafter the copper foil on the surface was removed by etching to provide a measurement sample. This measurement sample was used to measure the reflectance at 457 nm using a spectrophotometer (manufactured by Konica Minolta Inc.: CM3610d) according to JIS Z-8722 (average value for n = 5).
6) Reflectance after heating: the sample obtained in 5) was subjected to a heating treatment by a hot air dryer at 180°C for 24 hours, and thereafter the reflectance was measured in the same manner as in the measurement of the reflectance in 5) (average value for n = 5).
7) Reflectance after heating and light irradiation: the sample obtained in 5) was subjected to a heating and light irradiation treatment (ultraviolet irradiation intensity: 100 mW/cm²) on a hot plate at 180°C installed in a weather meter and dryer (SUV-F11 manufactured by Iwasaki Electric Co., Ltd.) at an ultraviolet (wavelength: 295 to 450 nm) irradiation intensity of 100 mW/cm² for 24 hours, and thereafter the reflectance was measured in the same manner as in the measurement of the reflectance in 5) (average value for n = 5).
8) Tg: the resulting both-surface copper foil-clad laminate was cut by dicing saw to a size of 12.7 × 2.5 mm, and thereafter the copper foil on the surface was removed by etching to provide a measurement sample. This measurement sample was used to measure the glass transition temperature with a dynamic viscoelasticity analyzer (manufactured by TA Instruments) by the DMA method according to JIS C6481 (average value for n = 3).
9) Peel strength: the resulting both-surface copper foil-clad laminate was cut by dicing saw to a size of 10 × 100 mm, and thereafter a measurement sample in which the copper foil on the surface remained was obtained. According to a test method of a copper-clad laminate for a printed-wiring board defined in JIS C6481 (see 5.7 peeling strength.), Autograph (manufactured by Shimadzu Corporation: AG-IS) was used to measure the peeling strength of the copper foil of the measurement sample (average value for n = 5).
10) Solder heat resistance after moisture absorption: the resulting both-surface copper foil-clad laminate was cut by dicing saw to a size of 50 mm × 50 mm, and thereafter a measurement sample in which the copper foil on the surface remained was obtained. This measurement sample was used, and the change in outer appearance thereof after the sample was immersed in a solder tank at 280°C for 30 minutes was visually observed (number of samples in which swelling occurred/number of samples tested: n = 5).

The evaluation results are shown in Tables 3 and 4.

**[Table 3]**

| | | Example 6 | Example 7 | Example 8 | Example 9 | Example 10 |
|---|---|---|---|---|---|---|
| Characteristics of PP | Outer appearance of prepreg | ○ | ○ | ○ | ○ | ○ |
| | Viscosity of prepreg (P·s) | 500 | 3000 | 3000 | 3000 | 500 |
| | Preservation stability | ○ | ○ | ○ | ○ | ○ |
| Characteristics of copper-clad laminate | Inner appearance of copper-clad laminate | ⊚ | ⊚ | ⊚ | ⊚ | ⊚ |
| | Reflectance (%) | 90 | 89 | 90 | 90 | 90 |
| | Reflectance after heating (%) | 80 | 80 | 80 | 80 | 80 |
| | Reflectance after heating and light irradiation (%) | 75 | 75 | 75 | 75 | 75 |
| | Tg (°C) | 209 | 209 | 211 | 208 | 211 |
| | Peel strength (gf/cm) | 700 | 700 | 650 | 700 | 700 |
| | Solder heat resistance | 0/5 | 0/5 | 0/5 | 0/5 | 0/5 |

**[Table 4]**

| | | Comparative Example 5 | Comparative Example 6 |
|---|---|---|---|
| Characteristics of PP | Outer appearance of prepreg | ○ | ○ |
| | Viscosity of prepreg (P·s) | Unmeasurable | 2,000,000 |
| | Preservation stability | × | ○ |
| Characteristics of copper-clad laminate | Inner appearance of copper-clad laminate | ○ | × |
| | Reflectance (%) | 91 | 91 |
| | Reflectance after heating (%) | 81 | 81 |
| | Reflectance after heating and light irradiation (%) | 75 | 74 |
| | Tg(°C) | 184 | 210 |
| | Peel strength (gf/cm) | 700 | 650 |
| | Solder heat resistance | 0/5 | 0/5 |

It is to be noted that the present application is based on the priorities of Japanese Patent Application (Japanese Patent Application No. 2012-055598) filed with JPO on March 13, 2012 and Japanese Patent Application (Japanese Patent Application No. 2012-131983) filed with JPO on June 11, 2012, and the contents thereof are herein incorporated by reference.

### Industrial Applicability

As described above, the present invention can be widely and effectively utilized in various applications in which light resistance and heat resistance are demanded, such as an electrical/electronic material, a machine tool material and an aerospace material, and can be significantly effectively utilized in, in particular, the fields of a printed-wiring board and an LED-mounting printed-wiring board, in which excellent light resistance and heat resistance, and a high peel strength of metal foil are demanded.

## Claims

1. A resin composition comprising an epoxy-modified silicone compound (A), a branched imide resin (B) having an isocyanurate group and a carboxyl group, a phosphorus curing accelerator (C), titanium dioxide (D) and a dispersant (E).

2. The resin composition according to claim 1, wherein the branched imide resin (B) is at least one selected from the group consisting of an epoxy-modified branched imide resin, an alcohol-modified branched imide resin and an amine-modified branched imide resin.

3. The resin composition according to claim 1 or 2, wherein the branched imide resin (B) has an acid value of 10 to 200 mgKOH/g.

4. The resin composition according to any one of claims 1 to 3, wherein the branched imide resin (B) has an acid value of 10 to 100 mgKOH/g.

5. The resin composition according to any one of claims 1 to 4, further comprising a monomeric epoxy compound (F) having one or more epoxy rings, other than the compound (A).

6. The resin composition according to claim 5, wherein an epoxy equivalent of the monomeric epoxy compound (F) is 0.1 to 0.8 equivalents relative to a carboxyl residue of the branched imide resin (B).

7. The resin composition according to claim 5 or 6, wherein the monomeric epoxy compound (F) is at least one selected from the group consisting of compounds represented by the following formulae (8) to (10).

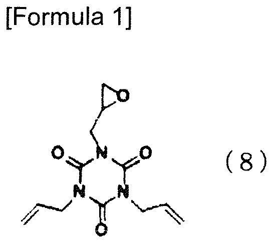

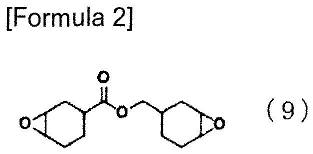

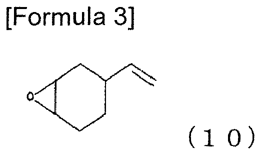

8. The resin composition according to any one of claims 1 to 7, wherein the epoxy-modified silicone compound (A) is an aliphatic epoxy-modified silicone compound.

9. The resin composition according to any one of claims 1 to 8, wherein the epoxy-modified silicone compound (A) is a silicone compound having a repeating unit represented by the following formula (1), having at least three R' in one molecule, and not having any alkoxy groups: 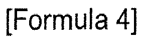 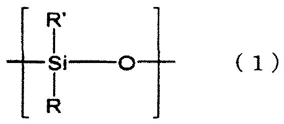 wherein R represents a hydrogen atom, or a substituted or non-substituted monovalent hydrocarbon group, and R' represents an organic group having an epoxy group.

10. The resin composition according to any one of claims 1 to 9, comprising the epoxy-modified silicone compound (A) in an amount of 20 to 80 parts by mass based on 100 parts by mass of the total of the components (A) and (B).

11. The resin composition according to any one of claims 1 to 10, wherein the branched imide resin (B) is represented by the following formula (6): 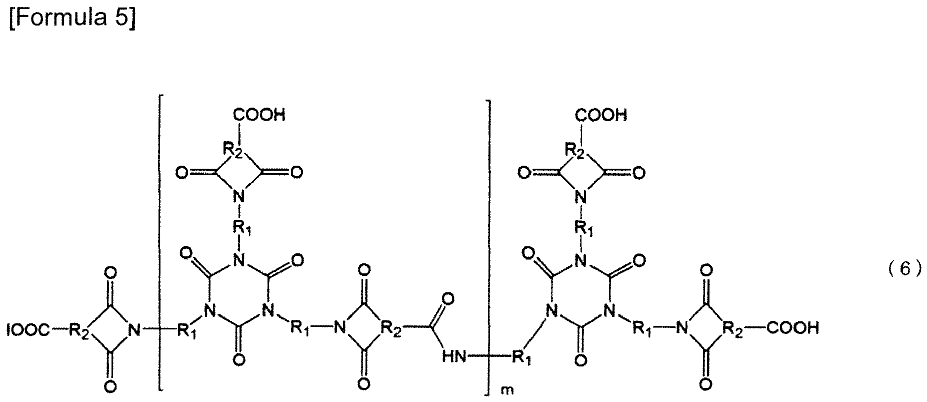 wherein each R₁ independently represents a divalent alicyclic group, each R₂ independently represents a trivalent alicyclic group, and m represents an integer of 1 to 10.

12. The resin composition according to any one of claims 1 to 11, further comprising a silane coupling agent (H).

13. The resin composition according to any one of claims 1 to 12, comprising the phosphorus curing accelerator (C) in an amount of 0.1 to 10 parts by mass based on 100 parts by mass of the total of the components (A) and (B).

14. The resin composition according to any one of claims 1 to 13, comprising the titanium dioxide (D) in an amount of 10 to 300 parts by mass based on 100 parts by mass of the total of the components (A) and (B).

15. The resin composition according to any one of claims 1 to 14, wherein the titanium dioxide (D) has an average particle size of 5 µm or less.

16. The resin composition according to any one of claims 1 to 15, wherein the titanium dioxide (D) has a surface treated with SiO₂, Al₂O₃, ZrO₂ and/or ZnO; and SiO₂ is contained in an amount of 0.5 to 15 parts by mass, Al₂O₃ is contained in an amount of 0.5 to 15 parts by mass, ZrO₂ is contained in an amount of 0.5 to 15 parts by mass and/or ZnO is contained in an amount of 0.5 to 15 parts by mass, based on 100 parts by mass of the total amount of the titanium dioxide (D).

17. The resin composition according to any one of claims 1 to 16, comprising the dispersant (E) in an amount of 0.05 to 10 parts by mass based on 100 parts by mass of the total of the components (A) and (B).

18. The resin composition according to any one of claims 1 to 17, wherein the dispersant (E) is a polymer-based wetting dispersant having an acid value of 20 to 200 mgKOH/g.

19. The resin composition according to any one of claims 1 to 18, further comprising an alicyclic epoxy resin (G).

20. The resin composition according to claim 19, wherein the alicyclic epoxy resin (G) is at least one selected from the group consisting of an alcohol adduct of vinylcyclohexene diepoxide, an alcohol adduct of 3,4-epoxycyclohexanecarboxylic acid-3',4'-epoxycyclohexylmethyl, an alcohol adduct of bis(3,4-epoxycyclohexylmethyl) adipate, an alcohol adduct of dicyclopentadiene diepoxide, an alcohol adduct of ε-caprolactone-modified bis(3,4-epoxycyclohexylmethyl)-4,5-epoxycyclohexane-1,2-dicarboxylic acid, an alcohol adduct of ε-caprolactone-modified tetra(3,4-epoxycyclohexylmethyl)butane-tetracarboxylic acid, an alcohol adduct of dipentene dioxide, an alcohol adduct of 1,4-cyclooctadiene diepoxide and an alcohol adduct of bis(2,3-epoxycyclopentyl)ether.

21. The resin composition according to claim 5, prepared by subjecting the branched imide resin (B), the phosphorus curing accelerator (C) and the monomeric epoxy compound (F) to a pretreatment with reflux in the presence of a solvent, and then blending the epoxy-modified silicone compound (A), the titanium dioxide (D) and the dispersant (E) therewith.

22. A resin composition comprising an epoxy-modified silicone compound (A), a branched imide resin (B) having an isocyanurate group and a carboxyl group, a phosphorus curing accelerator (C), titanium dioxide (D), a dispersant (E), a monomeric epoxy compound (F) having one or more epoxy rings, other than the (A), and an alicyclic epoxy resin (G),
wherein the resin composition comprises the branched imide resin (B) in an amount of 10 to 80 parts by mass based on 100 parts by mass of the total of the epoxy-modified silicone compound (A), the branched imide resin (B), the monomeric epoxy compound (F) and the alicyclic epoxy resin (G).

23. The resin composition according to claim 22, comprising the titanium dioxide (D) in an amount of 10 to 400 parts by mass based on 100 parts by mass of the total of the epoxy-modified silicone compound (A), the branched imide resin (B), the monomeric epoxy compound (F) and the alicyclic epoxy resin (G).

24. The resin composition according to claim 22 or 23, comprising the dispersant (E) in an amount of 0.05 to 5 parts by mass based on 100 parts by mass of the total of the epoxy-modified silicone compound (A), the branched imide resin (B), the monomeric epoxy compound (F) and the alicyclic epoxy resin (G).

25. A resin composition comprising an epoxy-modified silicone compound (A), a branched imide resin (B) having an isocyanurate group and a carboxyl group, titanium dioxide (D), a dispersant (E), and a monomeric epoxy compound (F) having one or more epoxy rings, other than the (A).

26. The resin composition according to any one of claims 1 to 25 used for an LED-mounting printed-wiring board.

27. A prepreg obtained by impregnating or coating a substrate with the resin composition according to any one of claims 1 to 25.

28. A metal foil-clad laminate obtained by stacking at least one or more sheets of the prepreg according to claim 27, disposing metal foil on one or both surfaces of the resultant, and lamination-forming.

29. A printed-wiring board comprising an insulation layer, and a conductor layer formed on a surface of the insulation layer, wherein the insulation layer comprises the resin composition according to any one of claims 1 to 25.
